# EUROPEAN PATENT SPECIFICATION

(11) **EP 1 581 031 B1**
(45) Date of publication and mention of the grant of the patent: **06.10.2010**
(21) Application number: 05006375.9
(22) Date of filing: 23.03.2005
(51) Int. Cl.: H05K 3/18

(54) **Methods of forming a pattern and a conductive pattern**
Verfahren zur Herstellung eines Musters und eines leitfähigen Musters
Procédés de formation d'un motif et un motif conducteur

(30) Priority: 25.03.2004 JP 2004090646; 25.03.2004 JP 2004090648; 25.03.2004 JP 2004090651
(43) Date of publication of application: 28.09.2005
(73) Proprietor: FUJIFILM Corporation, Minato-ku Tokyo (JP)
(72) Inventor: Kawamura, Koichi, Haibara-gun Shizuoka-ken (JP)
(74) Representative: HOFFMANN EITLE

(56) References cited:
- EP-A- 0 510 711
- US-A- 5 079 600
- US-B1- 6 436 615
- PATENT ABSTRACTS OF JAPAN vol. 017, no. 402 (P-1580), 27 July 1993 (1993-07-27) & JP 05 072735 A (SANNOPUKO KK), 26 March 1993 (1993-03-26)

## Description

### BACKGROUND OF THE INVENTION

### Field of the invention

The present invention is concerned with methods of forming a pattern and a conductive pattern.

### Description of the related art

Surface modification of solid surface with a polymer can alter properties such as the wettability, stain resistance, adhesiveness, surface friction, and affinity for cells. Therefore, the surface modification has been widely studied in various industrial fields. Particularly, the surface modification with a surface graft polymer directly connected to a solid surface through a covalent bond has gathered attention. This is because the bond between the surface and the polymer is advantageously strong, the affinity of a graft polymer for a substance is different from the affinity of a polymer formed by a general coating and cross-linking method, and the graft polymer exhibits specific properties based on this difference in affinity.

Applied technologies have been proposed which use the surface graft polymers having such advantages in various fields, and the surface graft polymer has been used in fields such as a field of living bodies (cell cultures, antithrombotic artificial blood vessels, artificial joints, etc.) hydrophilic films whose surface has to have high hydrophilicity, and hydrophilic supports of printing plates whose surface has to have high hydrophilicity. These applications utilize the specific properties of the graft polymers.

Furthermore, when such a surface graft polymer is formed in a pattern, the specific properties of the graft polymer can be exhibited according to the pattern. Therefore, the graft polymers are used in fields of printing plate precursors, compartmentalized cultures and dye image formation.

For instance, it has been reported that a hydrophilic graft pattern is formed by using a polymerization initiating group (called "iniferter") fixed on a surface, and used as a cellular compartmentalized culture material (Matuda et al. "Journal of biomedical materials research", 53, 584 (2000)). It has also been reported that a dye (toluidine blue dye) is adsorbed by the graft pattern to form a visible image pattern (Matuda et al. "Langumuir", 15, 5560 (1999)).

Furthermore, the following methods have been reported. For example, a method comprises polymerizing a hydrophilic or hydrophobic monomer in a pattern to obtain a polymer pattern by using an iniferter polymerization initiator fixed on the surface, and another method comprises grafting a monomer having a dye structure to form a dye polymer pattern (A. T. Metters et al. "Macromolecules", 36, 6739 (2003)). Another method comprises imagewise attaching an initiator onto a gold plate using a micro-contact printing method, causing an atom transfer polymerization (ATRP polymerization) from the initiator to form a graft polymer of HEMA (hydroxy ethyl methacrylate) or MMA (methyl methacrylate) in a pattern, and using the obtained pattern as a resist (C.J. Hawker "Macromolecules", 33, 597 (2000)).

Further, Ingall et al., "J. Am. Chem. Soc", vol. 121, p. 3607 (1999), proposed a method of forming a pattern of graft polymer by anion or cation radical polymerization from a silane compound immobilized on a substrate.

However, it takes a long time if a graft pattern is formed by using the conventional iniferter method or the atom transfer radical polymerization method described above. Thereby, the conventional methods have a drawback in productivity. Since the anion radical polymerization method and the cation radical polymerization method require strict control of the polymerization reaction, they also have a disadvantage in productivity.

Although there exists a need for a pattern forming method for providing surface-modified materials and high-performance materials effectively by modifying a solid surface with a graft polymer, there have been no method by which a graft polymer pattern can be easily formed in a practical production time.

So far, various kinds of conductive patterned materials are used in the formation of wiring boards. Typical conductive patterns are formed by providing a conductive substance thin film prepared by a known method such as a vapor deposition method on an insulator, subjecting the conductive substance to a resist treatment, conducting a pattern exposure, partially removing the resist, and conducting an etching treatment to form a desired pattern. The method includes at least four steps. When a wet etching is carried out, the waste liquid of the wet etching has to be suitably processed. Therefore, the method involves complicated processes (JP-A No. 2004-31588).

Another pattern formation method is known which involves use of a photoresist to form a conductive patterned material. The method comprises coating a base material with a photoresist polymer or attaching a photoresist on a dry film to a base material, exposing the photoresist with an arbitrary photomask to UV to form a pattern such as a lattice pattern. The method is useful for forming an electromagnetic wave shield which has to have a high conductivity.

The development of micromachines have progressed and ULSI (Ultra Large-Scale Integration) have been further downsized in recent years. Accordingly, a wiring structure thereof has to be fine at a nanometer level. The ability of the conventional metal etching to form fine wiring structure is limited and breaking of wire during processing of fine wires is likely to occur. Accordingly, there have been needs for a pattern formation method which is capable of forming a fine pattern whose orientation is controlled.

Further, various methods have been recently proposed which form patterns directly from digital data without using masks or the like. It is expected that fine patterns can be formed arbitrarily by using such methods. An example of such method uses a self-assembling monomolecular film. The method utilizes a molecular assembly which is spontaneously formed when a substrate is immersed in an organic solvent containing surfactant molecules. The combination of the material and the substrate may be, for instance, a combination of an organic silane compound and a SiO₂ or Al₂O₃ substrate, or a combination of alcohol or amine and a platinum substrate. According to this method, patterns can be formed by the photolithography method or the like. Such monomolecular films enable formation of a fine pattern. However, such a method is difficult to put into practice since the combination of the substrate and the material is limited. Accordingly, pattern formation techniques have not been developed which can be practically applied to form fine wiring.

In order to obtain a patterned material which is light, flexible, and friendly to the environment, organic transistors using a conductive polymer pattern have been studied. The supports comprising such organic materials are capable of easily forming (by a technique similar to printing at room temperature) an element which is light, thin, and flexible and which has a large area. Such features of the organic materials can be combined with electrical and optical characteristics of organic semiconductors which are under development. Such combinations are expected to enhance the development of a technology for the personalization of information, which is most strongly required in the present information technology. An example of the technology for the personalization is a technique of manufacturing wearable portable terminals with simple information processing functions and easily operable I/O functions. However, the technique has insufficient characteristics from the practical viewpoints of the durability, area expandability, stability in conductivity and productivity.

It has also been proposed to form a conductive pattern by using a highly hydrophilic graft polymer. An example of the methods comprises providing a hydrophobic compound in a pattern on a surface having a hydrophilic graft polymer on its entire surface to form a hydrophilichydrophobic pattern, and attaching a conductive substance to hydrophilic graft regions (JP-A No. 2003-345038). Another example comprises forming a hydrophilic graft polymer on the entire surface of a base material, and attaching a conductive substance in a pattern on the surface by ink-jet or the like (JP-A No. 2003-234561). Another example comprises forming a graft polymer locally on the surface of a base material to form a hydrophilic graft polymer pattern, and attaching a conductive polymer to the hydrophilic graft portion (JP-A No. 2003-188498). All of these methods have an advantage that a pattern can be easily formed based on the digital data. However, the resolution of the pattern is insufficient. In the first and second examples, the resolution is limited at the process of attaching a conductive substance in a pattern. In the third method, a hydrophilic graft pattern is formed by providing a hydrophilic/hydrophobic polarity-switching graft polymer on the entire surface of a substrate and locally switching the polarity by imagewise exposing the resulting substrate to an infrared-laser light. In the third method, it is difficult to obtain a high-resolution pattern at a level of 10 µm or less because of the limitation on the beam diameter of the infrared laser. In another aspect of the third method, a hydrophilic graft polymer is formed locally by using a surface grafting reaction. In this aspect, a monomer solution is coated on a substrate and then the substrate is subjected to an imagewise exposure. This aspect also has a problem that the monomer coating layer is thick, thus the refractive index of the coating layer is likely to affect the exposure. Consequently, it is difficult to obtain a high resolution.

Not only a continuous metal thin film but also a fine metal particle pattern has attracted attention in which metal particles are adsorbed selectively to specific areas.

In recent years, the society has become an advanced information society, and electronic devices have developed remarkably. In particular, the development of the computer technology supports the advanced information society. Factors which develop the computer technology include higher integration of semiconductor LSIs and a higher recording density of magnetic discs. In realizing the higher recording density of the magnetic disc, the defects in the magnetic layer has to be minimized and the smoothness of the layer has to be improved.

In order to realize these objects, a film has been used in which metal particles having magnetic characteristics are dispersed on the surface of a base material. It is known that the recording capacity can be increased when the metal particles are patterned. Therefore, it has become important to dispose the metal particle adsorption region in a pattern. The formation of the fine metal particle pattern for increasing the recording density also has problems similar to in the case of the metal thin film pattern. Accordingly, it has been difficult to form a metal particle pattern which is fine and which has a high resolution.

A process for producing electroconductive patterns on a substrate has also been described comprising the chemical adsorption of a monomolecular film onto the substrate surface followed by altering the activity of predetermined regions of the monomolecular film surface (US-B-5,079,600). A catalyst is adhered to the unaltered regions and not to the altered regions such that immersion of the substrate in an electroless metal plating bath provides a metal plate on the unaltered regions of the monomolecular film but not the altered regions. Electroconductive patterns produced in this way exhibit high resolution between the conductive and non-conductive regions.

Another process for producing an electroconductive pattern comprises the selective activation of predetermined regions of a substrate by exposure to actinic radiation through a mask (US-B-6,436,615). The activated regions are then reacted with a compound containing groups which either bind to a metal directly or bind to a catalyst on which a metal is adhered, thereby producing a well-defined electrocondutive pattern on the activated regions of the substrate.

### SUMMARY OF THE INVENTION

The present invention has been achieved, considering the problems associated with the conventional methods. According to the invention, it is possible to provide a method of forming a pattern that allows easier formation of a high-resolution graft polymer pattern on a solid surface.

A first aspect of the invention provides a pattern forming method. The pattern forming method comprises: binding a compound (Q-Y) having a photopolymerization initiation site (Y) and a substrate binding site (Q) to a substrate; subjecting the substrate surface to a pattern exposure so as to inactivate the photopolymerization initiation site in the exposed region; bringing a radical polymerizable unsaturated compound into contact with the surface of the substrate; and subjecting the substrate surface to an entire-surface exposure to light so as to cause a photochemical cleavage of the photopolymerization initiation site (Y) remaining in the region which was not exposed in the pattern exposure, to initiate a radical polymerization, and to generate a graft polymer. The photopolymerization initiation site (Y) is capable of initiating a radical polymerization by a photocleavage thereof. The compound having a photopolymerization initiation site and a substrate binding site is occasionally referred to as "compound (Q-Y)" hereinafter.

It is possible to form a graft polymer pattern easily on the solid surface supposedly because: the radical polymerization reaction in the invention is a polymerization reaction involving a free radical, thus the polymerization proceeds fast, and it is not necessary to control the polymerization reaction strictly.

According to the pattern forming method of the first aspect, it is possible to easily form a high-resolution graft polymer pattern on a solid surface.

The invention also provides a method of forming a high-resolution conductive patterned material having excellent productivity, durability, and stable conductivity, the method being simple and excellent in productivity.

A second aspect of the invention provides a method of forming a conductive pattern. The method of forming a conductive pattern comprises the pattern-forming method according to the above first aspect and adhering a conductive material to the graft polymer to form a conductive pattern.

In the second aspect of the invention, the graft polymer preferably has a polar group. In particular, the polymer preferably has a polar group on a side chain thereof. The polar group is preferably an ionic group that can dissociate into ions. Further, the region (occasionally referred to as "graft polymer region" hereinafter) on the surface where the graft polymer was formed is preferably hydrophilic.

In the second aspect of the invention, polymerization initiation sites in the exposed region are inactivated when the compound (Q-Y) bound to the substrate surface is subjected to a pattern exposure. The polymerization initiation sites remaining in the nonexposed region are subjected to an entire-face exposure and photocleaved. The photocleavage initiates a radical polymerization which forms a graft polymer. As described above, a pattern exposure is conducted prior to the graft formation, and the pattern exposure changes the exposed region to a region where graft polymer cannot be formed. Therefore, it is possible to form a high-resolution graft polymer region corresponding to the exposure pattern.

The graft polymer prepared by the second aspect is strongly immobilized on the substrate, since one terminal of the graft polymer binds chemically to the compound (Q-Y) which binds to the substrate surface. Because only one of the terminals of the polymer is immobilized on the substrate and the other terminal is not fixed, the movement of the polymer is not strictly restricted and the polymer is highly mobile. As recited above, the generated graft polymer has a high motility, and is formed on the substrate at high resolution and bound to the substrate firmly. Since the graft polymer has the above characteristics, the graft polymer region can be converted to a high-resolution hydrophilic region having a mobile hydrophilic graft polymer by introducing a highly hydrophilic functional group into the molecule. The highly hydrophilic functional group may be a polar group.

When the surface is provided with a conductive material which can be selectively adsorbed by the hydrophilic region (graft polymer region), the hydrophilic region is converted to a conductive region by the adsorption of the conductive material. The region not having a graft polymer becomes a non-conductive region since the conductive material is not adsorbed by such a region. As a result, a conductive pattern (circuit) is formed. The conductive region thus formed is superior in durability and conductivity stability, presumably because the conductive material strongly and ionically adsorbed by the hydrophilic functional group on the hydrophilic graft polymer can form a monomolecular film or a polymer layer.

A third aspect of the invention provides a method for forming a conductive pattern. The conductive pattern forming method comprises the pattern-forming method according to the above first aspect; adhering a metal ion or a metal salt to the graft polymer region; and reducing the metal ion or the metal ion in the metal salt to deposit the metal.

In the third aspect of the invention, the conductive pattern may be further subjected to a heating treatment after the reduction of the metal ion or the metal ion in the metal salt.

In the third aspect, the graft polymer preferably has a polar group in the polymer. In particular, the graft polymer has a polar group on a side chain of the polymer. The polar group is preferably an ionic group that can dissociate into ions. Further, the graft polymer region in this embodiment is preferably a hydrophilic region.

In the third aspect of the invention, as described above, a metal ion or a metal salt is provided onto the graft polymer which is directly bound to the substrate, and the metal is deposited by the reduction of the metal ion or the metal ion in the metal salt. Therefore, a continuous thin metal film or a metal particle containing layer including dispersed metal particles adhered to the graft polymer is formed in a pattern. Such a thin metal film or metal particle containing layer has a high conductivity as well as a high strength and a high abrasion resistance.

The method of adding a metal ion and/or a metal salt in the third aspect may be (1) a method of allowing the graft polymer region having a polar group (ionic group) to adsorb the metal ion; (2) a method of impregnating the graft polymer region having a graft polymer including a compound (such as polyvinylpyrrolidone) having a high affinity for the metal salt with a metal salt or a solution containing a metal salt; (3) a method of impregnating the hydrophilic graft polymer region with a liquid including a metal salt or a solution in which the metal salt is dissolved.

The method (3) can provide a required metal ion or a required metal salt even if the graft polymer region has a positive charge.

A fourth aspect of the invention provides a conductive pattern forming method. The conductive pattern forming method comprises the pattern-forming method according to the above first aspect; adhering an electroless plating catalyst or a precursor thereof to the graft polymer region; and conducting an electroless plating to form a patterned thin metal film.

In the fourth aspect, a graft polymer having a functional group capable of interacting with an electroless plating catalyst or a precursor thereof is formed in a pattern, the electroless plating catalyst or the precursor thereof is provided onto the graft polymer region, and an electroless plating is conducted to form a thin metal film. Since the graft polymer having a functional group capable of interacting with the electroless plating catalyst or the precursor thereof is bound to the substrate, the obtained thin metal film shows a high conductivity as well as a high strength and abrasion resistance.

A high-resolution graft polymer region can be easily formed on the substrate by a scanning exposure based on digital data or a pattern exposure with a mask pattern. It is possible to form a graft polymer pattern easily on the solid surface supposedly because: the radical polymerization reaction in the invention is a polymerization reaction using a free radical, thus the polymerization proceeds fast, and it is not necessary to control the polymerization reaction strictly.

The obtained graft polymer is strongly immobilized on the substrate, since one terminal of the graft polymer binds chemically to the compound (Q-Y) which binds to the substrate surface. Because only one of the terminals of the polymer is immobilized on the substrate and the other terminal is not fixed, the movement of the polymer is not strictly restricted and the polymer is highly mobile.

Accordingly, even if the thickness of the graft polymer region is small, the graft polymer pattern has high precision and strength. When a metal salt or the like is ionically adhered (adsorbed) to the graft polymer, the adsorbed molecules are firmly fixed. Therefore, the metal region is strong even when its thickness is small. When the metal region is a thin metal film (continuous film), a fine wiring pattern without breakage can be formed.

The graft polymer has a remarkably high mobility as described above. Therefore, the adsorption rate is very high and the amount of metal ions or metal salts adsorbable by a unit area is large, when compared with a case where a general cross-linked polymer film is allowed to adsorb a metal salt. Accordingly, a fine wiring pattern can be formed when an amount of adsorbed metal is controlled so as to form a continuous metal thin film or a dense metal particle adsorption layer is heated to fuse adjacent particles to form a continuous metal layer. When such a wiring is formed, the conductivity is not disturbed by a gap between metal particles and the disconnection does not occur.

In every aspect, the processes may be conducted in the order of the description. The polymerization initiation site preferably includes a bond selected from the group consisting of a C-C bond, C-N bond, C-O bond, C-Cl bond, N-O bond, and S-N bond.

### BRIEF DESCRIPTION OF THE DRAWINGS

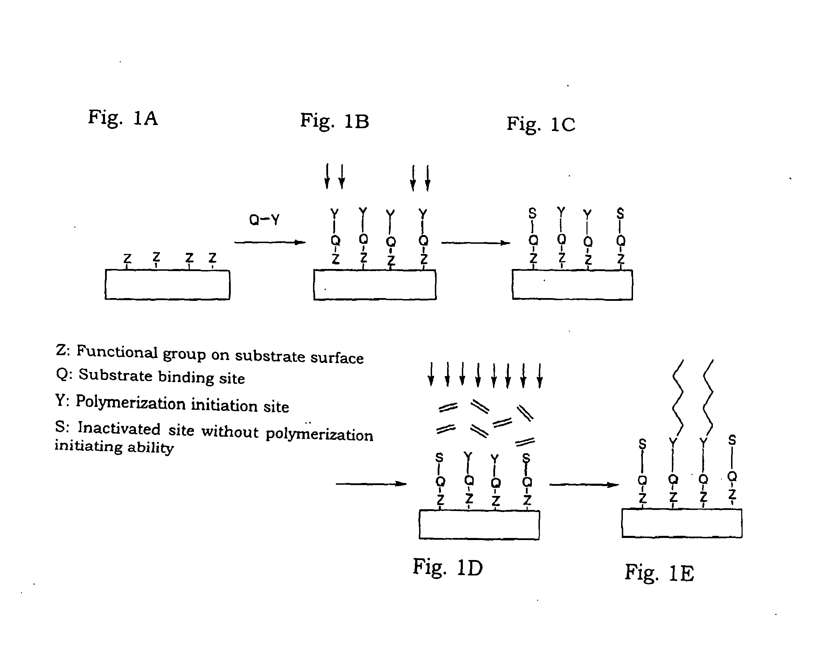

Fig. 1A through 1E are schematic diagrams illustrating the processes of the invention from the binding of the photocleavable compound to the graft polymer formation.

### DESCRIPTION OF THE PRESENT INVENTION

Hereinafter, the present invention will be described in detail.
The pattern forming method (A') of the invention comprises in the sequential order: binding a compound (Q-Y) to a substrate wherein the compound (Q-Y) has a photopolymerization initiation site capable of intiating radical polymerization by photocleavage thereof and a substrate binding site; subjecting the substrate surface to a pattern exposure and inactivating the photopolymerization initiation site in the exposed region; bringing a radical polymerizable unsaturated compound into contact with the surface of the substrate; and subjecting the substrate surface to an entire-surface exposure so as to cause a photochemical cleavage of the photopolymerization initiation site remaining in the region which was not exposed in the pattern exposure, to initiate a radical polymerization, and to generate a graft polymer.

The outline of the pattern forming method (A') will be described with reference to Figs. 1A to 1E. Figs. 1A to 1E are conceptual diagrams illustrating the outline of the method of the invention.

As shown in Fig. 1A, the surface of the substrate inherently has functional groups (represented by Z in the Figure) thereon. A compound (Q-Y) having a substrate binding site (Q) and a polymerization initiation site (Y) capable of initiating radical polymerization by photocleavage is brought into contact with the substrate surface. As shown in Fig. 1B, the functional group (Z) present on the substrate surface and the substrate binding site (Q) bind to each other, so that the compound (Q-Y) is bound to the substrate surface. Subsequently, the surface having the compound (Q-Y) is subjected to a pattern exposure as indicated by the arrow in Fig. 1B. The polymerization initiation sites (Y) are photo-cleaved by the exposure energy. As a result, as shown in Fig. 1C, polymerization initiation site (Y) in the compound (Q-Y) in the exposed are inactivated and become an inactivated site (S) which no longer has the polymerization initiating capability.

Then as shown in Fig. 1D, the entire surface is exposed to light in the presence of a known graft polymer material such as a monomer or the like as indicated by the arrow in Fig. 1D. As shown in Fig. 1E, a graft polymer is generated with the polymerization initiation site (Y) of the compound (Q-Y) working as the initiation point, in the region still having the intact polymerization initiation sites (Y).

The conductive patterned material (B) of the invention is prepared by: subjecting a substrate surface having the compound (Q-Y) bound to the surface to a pattern exposure so as to inactivate the photopolymerization initiation site in the exposed region; bringing a radical polymerizable unsaturated compound into contact with the surface of the substrate; subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; and adhering a conductive material to the graft polymer.

The conductive pattern forming method of the invention (B') comprises in the sequential order: binding the compound (Q-Y) to a substrate; subjecting the substrate surface to a pattern exposure so as to inactivate the photopolymerization initiation site in the exposed region; bringing a radical polymerizable unsaturated compound into contact with the surface of the substrate; subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; and adhering a conductive material to the graft polymer. In the conductive patterned material (B) and conductive pattern forming method (B'), the graft polymer is generated in the same manner as in the pattern forming method (A').

The conductive pattern forming method (C') comprises: binding the compound (Q-Y) to a substrate; subjecting the substrate surface to a pattern exposure so as to inactivate the photopolymerization initiation site in the exposed region; bringing a radical polymerizable unsaturated compound into contact with the surface of the substrate; and subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; providing a metal ion or a metal salt to the graft polymer region; and reducing the metal ion or the metal ion in the metal salt to deposit the metal.

The conductive pattern forming method (D') comprises: binding a compound having a photopolymerization initiation site and a substrate binding site to a substrate; subjecting the substrate surface to a pattern exposure so as to inactivate the photopolymerization initiation site in the exposed region; bringing a radical polymerizable unsaturated compound into contact with the surface of the substrate; and subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; providing an electroless plating catalyst or a precursor thereof to the graft polymer region; and conducting an electroless plating to form a patterned thin metal film.

In the methods (C') and (D'), the graft polymer is generated in the same manner as in the pattern forming method (A').

### Generation of Graft Polymer

Hereinafter, constitutions common to pattern forming methods and the conductive pattern forming methods of the invention will be described specifically.

The group represented by Z in Figs. 1A to 1E is a functional group present on the substrate surface, and typical examples thereof include a hydroxyl group, a carboxyl group, and an amino group. The functional group may be a functional group which is inherently present on the substrate surface and which derives from the substrate material such as silicon and glass substrates, or a functional group newly introduced onto the substrate surface by a surface treatment such as the corona treatment.

The structure of the compound (Q-Y) having a substrate binding site and a polymerization initiation site (hereinafter, referred to simply as "polymerization initiation site") capable of initiating radical polymerization by photocleavage will be described specifically. Referring to the model compound (Q-Y) having a substrate binding site (Q) and a polymerization initiation site (Y) shown in the conceptual diagrams of Figs. 1B to 1E, the polymerization initiation site (Y) generally has a structure including a photocleavable single bond.

The photocleavable single bond may be a single bond capable of being cleaved by α- or β-cleavage reaction of carbonyl, photo-Fries rearrangement reaction, cleavage reaction of phenacyl esters, sulfonimide cleavage reaction, sulfonyl ester cleavage reaction, N-hydroxysulfonyl ester cleavage reaction, benzylimide cleavage reaction, cleavage reaction of activated halogen compounds, or the like. The photocleavable single bond are cleaved in such a reaction. Examples of the cleavable single bond include C-C, C-N, C-O, C-Cl, N-O, and S-N bonds.

The polymerization initiation site (Y) including a photocleavable single bond functions as the initiation site for graft polymerization in the formation of the graft polymer. The cleavage reaction of the photocleavable single bond leads to generation of a free radical. The structure of the polymerization initiation site (Y) having a photocleavable single bond and capable of generating a free radical may be a structure including a group such as an aromatic ketone group, a phenacyl ester group, a sulfonimide group, a sulfonyl ester group, an N-hydroxysulfonyl ester group, a benzylimide group, a trichloromethyl group, or a benzyl chloride group.

The polymerization initiation site (Y) is cleaved by exposure to generate a free radical. If a polymerizable compound is present in the vicinity of the free radical, the free radical functions as the initiation site for graft polymerization and a desired graft polymer is formed. The obtained region having the graft polymer is occassionally referred to as "graft polymer region" hereinafter.

On the contrary, if a polymerizable compound is not present in the vicinity of the radical, which is generated by the cleavage of the polymerization initiation site (Y) by exposure, the radical is inactivated without initiating polymerization. Consequently, the region loses the polymerization initiating ability. As a result, graft polymer is not formed on the region and the region having the inactivated initiation site and not having the graft polymer is occasionally referred to as graft-polymer-free region.

The substrate binding site (Q) has a reactive group that can react with the functional group present on the substrate surface (Z), and typical examples of the reactive groups include the following groups:

Q: Substrate-binding site **―SiO(OMe)₃ ―SiCl₃ ―NCO ―CH₂Cl**

The polymerization initiation site (Y) and the substrate binding site (Q) may bind to each other directly or via a connecting group. The connecting group may be a group including an atom selected from the group consisting of carbon, nitrogen, oxygen, and sulfur, and specific examples thereof include a saturated hydrocarbon group, aromatic group, ester group, amide group, ureide group, ether group, amino group, and sulfonamide group. The connecting group may have an substituent, and examples of the substituent include an alkyl group, an alkoxy group, and a halogen atom.

Typical examples (exemplary compounds 1 to 16) of the compounds (Q-Y) are shown below, together with the indication of the cleavable bonds. These examples should not be construed as limiting the invention.

C-C bond cleavage compounds

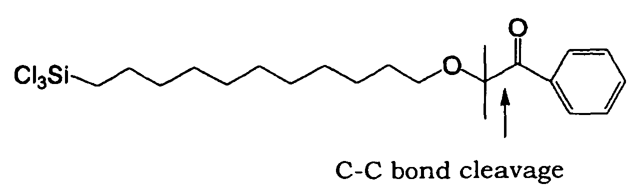

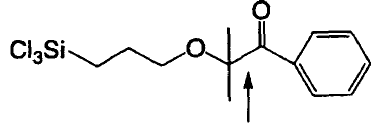

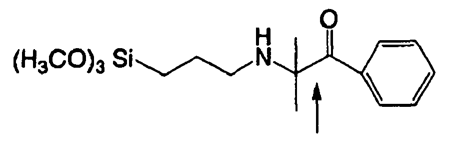

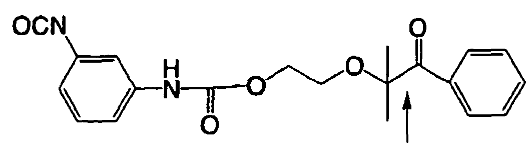

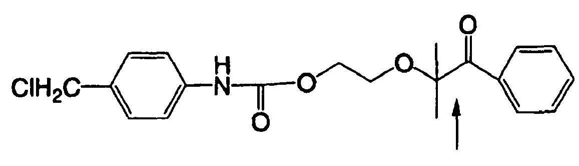

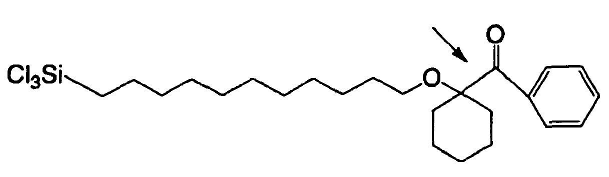

C-O bond cleavage compounds

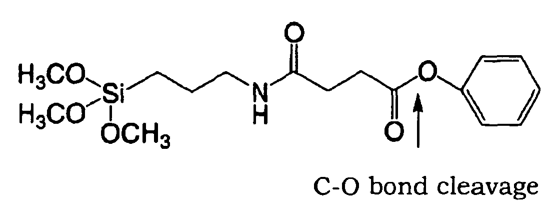

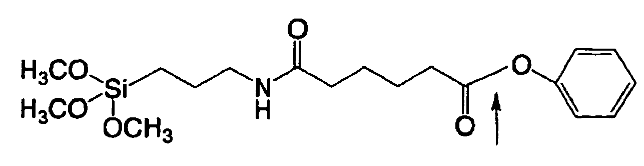

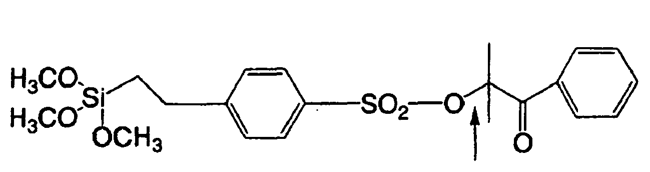

S-N bond cleavage compounds

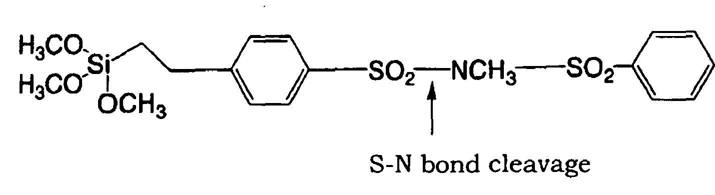

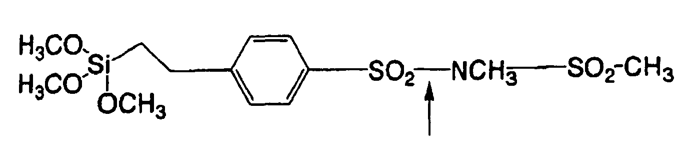

C-N bond cleavage compound

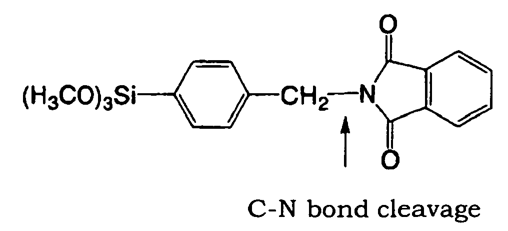

N-O bond cleavage compound

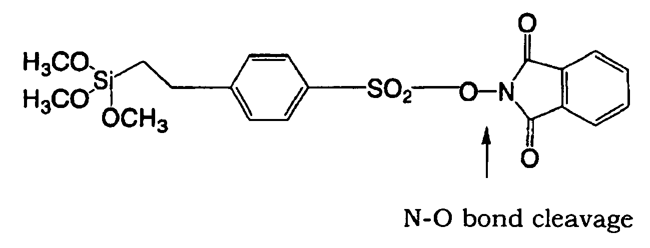

C-Cl bond cleavage compounds

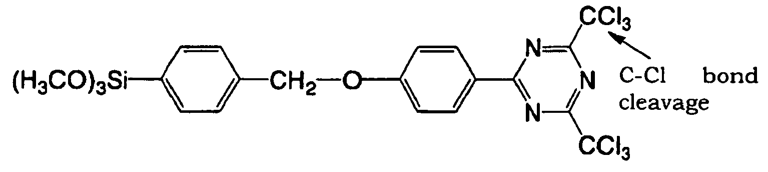

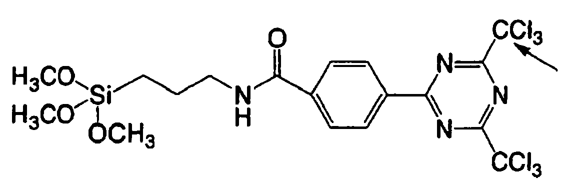

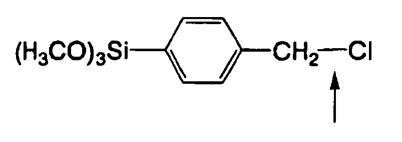

The compound (Q-Y) is bound to a substrate. The method for binding a compound (Q-Y) to the functional group Z present on the substrate surface may be: a method comprising dissolving or dispersing the compound (Q-Y) in a suitable solvent such as toluene, hexane, or acetone, and applying the solution or dispersion liquid onto the substrate surface; or a method comprising immersing the substrate in the solution or dispersion liquid. The concentration of the compound (Q-Y) in the solution or dispersion liquid is preferably 0.01 to 30% by mass and more preferably 0.1 to 15% by mass. When the liquid is brought into contact with the substrate surface, the liquid temperature is preferably 0 to 100°C. The contact time is preferably 1 second to 50 hours and more preferably 10 seconds to 10 hours.

The substrate used in the invention is not particularly limited. The substrate may be a substrate having thereon a functional group (Z) such as a hydroxyl group, a carboxyl group, or an amino group, or a substrate to which a hydroxyl, a carboxyl group, or the like were provided by a surface treatment such as the corona treatment, the glow discharge treatment, or the plasma treatment.

Although the substrate is usually a plate-shaped substrate, the substrate does not have to be plate-shaped. In an embodiment, a substrate having an arbitrary shape such as a cylindrical shape is used and the graft polymer is provided to the surface of the substrate in a similar manner.

Typical examples of the substrate include: various substrates having surface hydroxyl groups such as glass, quartz, ITO, and silicon; plastic substrates such as PET, polypropylene, polyimide, epoxy, acrylic, and urethane, groups such as a hydroxyl group and carboxyl group, the groups having been provided to the surface of the plastic substrates by surface treatments such as the corona treatment, the glow discharge treatment, and the plasma treatment.

The thickness of the substrate is not particularly limited and determined according to the applications, and is normally about 10 µm to 10 cm.

Subsequently, a pattern exposure is conducted on the region on the substrate surface which region is to be the graft-polymer-free region, and the compound (Q-Y) bound to the region is photo-cleaved and the polymerization initiating ability of the region is lost.

After the region retaining the polymerization initiation ability and the region without the polymerization initiating ability are formed, the graft polymer is formed on the region retaining the polymerization initiation ability.

In the formation of the graft polymer, the substrate is brought into contact with a radical polymerizable unsaturated compound (e.g., a hydrophilic monomer or the like), then the entire surface of the substrate is exposed to light so as to activate the polymerization initiation groups in the region retaining the polymerization initiating ability. The activated polymerization initiation group generates a free radical, and the free radical initiates the polymerization of the radical polymerizable unsaturated compound to form a graft polymer. As a result, a graft polymer is formed only in the region retaining the polymerization initiating ability.

The method for bringing the radical polymerizable unsaturated compound into contact with the substrate surface may be a method comprising coating the substrate with a solution or a dispersion liquid of the radical polymerizable unsaturated compound, or a method comprising immersing the substrate in the solution or the dispersion liquid.

The radical polymerizable unsaturated compound is not particularly limited as long as the compound has a radical polymerizable group. Examples thereof include hydrophilic monomers, hydrophobic monomers, macromers, oligomers, and polymers having polymerizable unsaturated groups. In an embodiment, the compound is a compound having a hydrophilic polar group such as a hydrophilic polymer, a hydrophilic macromer, or a hydrophilic monomer, in consideration of the adhesion or adsorption of conductive substances, metal ions, and metal salts.

Particularly, in the conductive pattern forming method (D'), the polymerizable compound is a compound having a radical polymerizable functional group and a functional group capable of interacting with the an electroless plating catalyst or a precursor thereof. The compound may be selected from the above-described compounds and the polar group may function as the functional group capable of interacting with an electroless plating catalyst or a precursor thereof.

Hereinafter, the radical polymerizable unsaturated compound used in the formation of the graft polymer of the invention will be described more specifically.

### -Hydrophilic polymer having α polymerizable unsaturated group

The "hydrophilic polymer having a polymerizable unsaturated group" refers to a hydrophilic polymer including a radical polymerizable group which may be an ethylenic addition-polymerizable unsaturated group such as a vinyl group, an allyl group, or a (meth)acrylic group. The hydrophilic polymer has a polymerizable group at the terminal of its main chain and/or on its side chain. In an embodiment, the hydrophilic polymer has polymerizable groups at the terminal of its main chain and on its side chain. Hereinafter, the hydrophilic polymer having a polymerizable group (at the terminal of its main chain and/or on its side chain) will be occasionally referred to as "hydrophilic polymer G".

The hydrophilic polymer G may be prepared by the following methods:
(a) a method comprising copolymerizing a hydrophilic monomer and a monomer having an ethylenic addition-polymerizable unsaturated group;
(b) a method comprising copolymerizing a hydrophilic monomer and a monomer having a double bond precursor and then introducing the double bond, for example by treatment with a base;
(c) a method comprising allowing functional groups of a hydrophilic polymer to react with a monomer having an ethylenic addition-polymerizable unsaturated group. From the viewpoint of synthesizability, the above method (c) is preferable.

In the methods (a) and (b), the hydrophilic monomer used for the preparation of the hydrophilic polymer G may be a monomer having a hydrophilic group such as: a carboxyl group, a sulfonic group, a phosphoric group, an amino group; a salt thereof; a hydroxyl group; an amide group; or an ether group. Examples of the hydrophilic monomer include: (meth)acrylic acid, alkali metal salts thereof, and amine salts thereof; itaconic acid, alkali metal salts thereof, and amine salts thereof; 2-hydroxyethyl (meth)acrylate; (meth)acrylamide; N-monomethylol (meth)acrylamide; N-dimethylol (meth)acrylamide; allylamine and hydrohalic acid salts thereof; 3-vinylpropionic acid, alkali metal salts thereof, and amine salts thereof; vinylsulfonic acid, alkali metal salts thereof, and amine salts thereof; 2-sulfoethyl (meth)acrylate; polyoxyethylene glycol mono(meth)acrylate; 2-acrylamide-2-methylpropanesulfonic acid; and acid phosphoxy polyoxyethylene glycol mono(meth) acrylate.

The hydrophilic polymer used in the method (c) may be a hydrophilic homopolymer of any of the above hydrophilic monomers or a copolymer including any of the above hydrophilic hydrophilic monomers.

The monomer having an ethylenic addition-polymerizable unsaturated group copolymerizable with a hydrophilic monomer used in the method (a) may be, for example, a monomer including an allyl group. In an embodiment, the monomer including an allyl group is allyl (meth)acrylate or 2-allyloxyethyl methacrylate.

The monomer having a double bond precursor copolymerizable with a hydrophilic monoer used in the method (b) may be, for example, 2-(3-chloro-1-oxopropoxy)ethyl methacrylate.

When the hydrophilic polymer G is prepared by the method (c), it is preferable to introduce an unsaturated group by using a reaction between a carboxyl group, an amino group or a salt thereof on the hydrophilic polymer and a functional group such as a hydroxyl group or an epoxy group. Examples of the monomer having an addition-polymerizable unsaturated group for the reaction include (meth)acrylic acid, glycidyl (meth)acrylate, allylglycidylether, and 2-isocyanatoethyl (meth)acrylate.

### -Hydrophilic macromonomer

The macromonomer used in the invention may be prepared by a method selected from various methods described, for example, in the second chapter "Synthesis of macromonomers" in "Chemistry and Industry of macromonomers" (Yuya Yamashita Ed.), published by Industrial Publishing & Consulting, Inc., Sep. 20, 1989.

Examples of the hydrophilic macromonomers usable in the invention include: macromonomers derived from monomers including carboxyl groups such as acrylic acid and methacrylic acid; sulfonic-acid-based macromonomers derived from monomers such as 2-acrylamide-2-methylpropanesulfonic acid, vinylstyrenesulfonic acid, and salts thereof; amide-based macromonomers derived from (meth)acrylamide, N-vinyl acetamide, N-vinyl formamide, and N-vinyl carboxylic acid amide monomer; macromonomers derived from hydroxyl-group-containing monomers such as hydroxyethyl methacrylate, hydroxyethyl acrylate, and glycerol monomethacrylate; and macromonomers derived from monomers including an alkoxy group or an ethylene oxide group such as methoxyethyl acrylate, methoxy polyethylene glycol acrylate, and polyethylene glycol acrylate. In addition, monomers having a polyethylene glycol or polypropylene glycol chain may also be used as the macaromonomer in the invention.

The hydrophilic macromonomer has a molecular weight preferably in the range of 250 to 100,000 and more preferably in the range of 400 to 30,000.

### -Hydrophilic monomer

Examples of the hydrophilic monomer include: monomers having positively-charged groups such as an ammonium group and a phosphonium group; monomers having negatively-charged or negatively-chargeable acidic groups such as a sulfuric acid group, carboxylic acid group, phosphoric acid group, and phosphonic acid group; hydrophilic monomers having non-ionic groups such as a hydroxyl group, an amide group, a sulfonamide group, an alkoxy group, and a cyano group.

Typical examples of the hydrophilic monomer usable in the invention include: (meth)acrylic acid, alkali metal salts thereof, and amine salts thereof; itaconic acid, alkali metal salts thereof, and amine salts thereof; allylamine and hydrohalic acid salts thereof; 3-vinylpropionic acid, alkali metal salts thereof, and amine salts thereof; vinylsulfonic acid, alkali metal salts thereof, and amine salts thereof; styrenesulfonic acid, alkali metal salts thereof, and amine salts thereof; 2-sulfoethylene (meth)acrylate; 3-sulfopropylene (meth)acrylate, alkali metal salts thereof, and amine salts thereof; 2-acrylamide-2-methylpropanesulfonic acid, alkali metal salts thereof, and amine salts thereof; acid phosphoxy polyoxyethylene glycol mono(meth)acrylate and salts thereof; 2-dimethylaminoethyl (meth)acrylate and hydrohalic acid salts thereof; 3- trimethylammoniumpropyl (meth)acrylate; 3-trimethylammoniumpropyl (meth)acrylamide; N,N,N-trimethyl-N-(2-hydroxy-3-methacryloyloxypropyl)ammonium chloride; 2-hydroxyethyl (meth)acrylate; (meth)acrylamide; N-monomethylol (meth)acrylamide; N-dimethylol (meth)acrylamide; N-vinylpyrrolidone; N-vinylacetamide; and polyoxyethylene glycol mono(meth)acrylate.

### -Solvent-

The solvent in which the radical polymerizable unsaturated compound is dissolved or dispersed is not particularly limited, as long as the solvent can dissolve the compound or optional additives.

For example, if a hydrophilic compound such as a hydrophilic monomer is used, the solvent is preferably an aqueous solvent such as water, a water-soluble solvent, a mixture of solvents selected from water and water-soluble solvents. Such a solvent may include a surfactant. The term "water-soluble solvent" used herein refers to a solvent miscible with water in any ratio, and examples thereof include alcoholic solvents such as methanol, ethanol, propanol, ethylene glycol, and glycerin; acids such as acetic acid; ketone solvents such as acetone; and amide solvents such as formamide.

If a hydrophobic compound such as a hydrophobic monomer is used, the solvent may be selected from alcoholic solvents such as methanol, ethanol, and 1-methoxy-2-propanol; ketone solvents such as methylethylketone; and aromatic hydrocarbon solvents such as toluene.

The exposure method employed in the pattern exposure for inactivating the polymerization initiating ability or in the entire-surface exposure for forming the graft polymer is not particularly limited as long as the exposure can provide sufficient energy for causing the cleavage in the polymerization initiation site (Y). The exposure may be ultraviolet exposure or visible-light exposure. In addition, the pattern exposure and the entire-surface exposure may be conducted under the same exposure condition or different exposure conditions.

The light (radiation) used for the exposures may be an ultraviolet light, a deep ultraviolet light, a visible light, or a laser beam. In an embodiment, the radiation is an ultraviolet light, the i line, the g line,or an excimer laser ratiation such as KrF or ArF. The i line, g line, and excimer lasers are favorable.

The resolution of the patterns formed by the invention depends on the exposure conditions.

By using the graft surface material of the invention, it is possible to form a pattern with high resolution. When the pattern exposure for high-definition image recording is conducted, a high definition pattern is formed in accordance with the exposure. The exposure method for forming a high definition pattern may be a light beam scanning exposure using an optical system or an exposure with a mask. The exposure method may be suitably selected in accordance with the resolution of the desired pattern. Examples of the high definition pattern exposure include stepper exposures such as the i-line stepper, g-line stepper, KrF stepper, and ArF stepper.

After a pattern formed by the graft polymer region and graft-polymer-free region is formed on the substrate surface by the exposure, the substrate with the pattern may be purified, for example by being washed with a solvent or immersed in a solvent so as to remove the remaining homopolymers. In an embodiment, the substrate with the pattern may be washed with acetone or water and dried. From a viewpoint of the removability of the homopolymers, ultrasonic washing with a solvent is preferable. After the purification, homopolymers do not remain on the surface of the substrate, and the only remaining graft polymer chains are the graft polymer chains strongly bonded to the substrate.

As described above, a fine pattern can be easily formed in accordance with the resolution of the exposure by the pattern forming method of the invention. Thus, the pattern can be used in a wider range of applications.

Hereinafter, the conductive material used for the conductive patterned material (B) and the conductive pattern forming method (B') are described together with the method for attaching the conductive materials.

In the conductive patterned material (B) and the conductive pattern forming method (B'), a conductive pattern can be obtained and a circuit can be formed by adhering a conductive substance to the graft polymer region. The method for adhering such a conductive substance may be:

(K) a method comprising adhering conductive particles to the graft polymer region; or

(L) a method comprising forming a conductive polymer layer on the graft polymer region.
The method can be appropriately selected in accordance with the application. In the following, the above methods will be described in detail.

### (K) Adhering conductive particles

The method (K) comprises ionically adhering a conductive particle to a polar group on the graft polymer by utilizing the polarities thereof. The conductive particles adhered to the graft polymer is strongly fixed in a state close to a monomolecular film; accordingly, only a small amount of the conductive particles gives a sufficient conductivity and the conductive patterned material can be used for forming a fine circuit.

The conductive particle usable in the method is not particularly limited as far as it is electrically conductive, and can be arbitrarily selected from particles of conventional conductive substances. Examples thereof include: metal particles of such as Au, Ag, Pt, Cu, Rh, Pd, Al and Cr; oxide semiconductor particles of such as In₂O₃, SnO₂, ZnO, CdO, TiO₂, CdIn₂O₄, Cd₂SnO₂, Zn₂SnO₄ and In₂O₃-ZnO; particles of substances obtained by doping the above substances with an impurity compatible with the substances; spinel compound particles of such as MgInO and CaGaO; conductive nitride particles of such as TiN, ZrN and HfN; conductive borate particles of such as LaB; and conductive polymer particles, which are organic substances.

### -Relationship between the polarity of hydrophilic group and conductive particle-

When the graft polymer has an anionic polar group (hydrophilic group) such as a carboxyl group, a sulfonic group, or a phosphonic group, the graft polymer region in the pattern selectively has a negative charge. By adhering thereto a positively charged (cationic) conductive particle, a conductive region (wiring) can be formed.

The cationic conductive particle may be, for example, a metal (oxide) particle having a positive charge. Particles having dense positive charges on their surfaces can be prepared, for example by a method of T. Yonezawa, which is described in T. Yonezawa, Chemistry Letters, 1061 (1999), T. Yonezawa, Langumuir, vol. 16, 5218 (2000) and T. Yonezawa, Polymer Preprints. Japan vol.49, 2911 (2000). Yonezawa et al. has demonstrated that a metal particle surface can be formed by using a metal-sulfur bond, the surface being densely chemically modified with functional groups having positive charges.

When the graft polymer has a cationic polar group (hydrophilic group) such as an ammonium group described in JP-A No. 10-296895, the graft polymer region in the pattern selectively has a positive charge. A conductive region (wiring) can be formed by adhering thereto a negatively charged conductive particle. The negatively charged metal particle may be, for example, gold or silver particles obtained by reduction with citric acid.

The particle size of the conductive particle used in the method is preferably 0.1 to 1000 nm, more preferably 1 to 100 nm. When the particle size is smaller than 0.1 nm, the conductivity tends to be low since the conductivity derives from continuous contact between surfaces of particles. When the particle size is larger than 1000 nm, the adhesion between the hydrophilic group on the graft polymer and the particle lowers and the strength of the conductive region is likely to be deteriorated.

These particles are preferably bound in the maximum amount adherable to the hydrophilic groups on the graft polymer from the viewpoint of durability. Furthermore, from a viewpoint of securing the conductivity, the concentration of the conductive particles in the conductive particle dispersion liquid is preferably about 0.001 to about 20 % by weight.

The method for adhering the conductive particle to the hydrophilic group on the graft polymer may be, for example: a method comprising applying a liquid including a dissolved or dispersed conductive particle having an electric charge thereon to a surface of the substrate on which graft polymer chains are formed imagewise; and a method comprising immersing such a substrate in such a liquid. In both of the methods, an excessive amount of the conductive polymer may be supplied, and the contact time between the liquid and the surface of the surface graft material is preferably about 10 sec to about 24 hr, and more preferably about 1 minute to about 180 minutes, in order to cause a sufficient amount of conductive particle to be bound to the polar group (hydrophilic group) by an ionic bond.

Only a single kind of conductive particle may be used or a plurality of kinds of conductive particles may be used in accordance with the necessity. Furthermore, in order to obtain a desired conductivity, a plurality of substances may be blended to form a particle.

### (L) Formation of conductive polymer layer

The method (L) for adhering a conductive substance comprises allowing the polar group on the graft polymer to ionically adsorb a conductive monomer, causing a polymerization of the conductive monomer to form a polymer layer (conductive polymer layer). Thus obtained conductive polymer layer is strong and excellent in durability. According to the method, it is possible to form a very thin film by controlling conditions such as the supply speed of the monomer. The resultant thin film is homogeneous and has a uniform film thickness.

The conductive polymer applicable to the method may be selected from polymer compounds with a conductivity of 10⁻⁶ s·m⁻¹ or higher, preferably 10⁻¹ s·cm⁻¹ or higher. Examples thereof include a conductive polyaniline, polyparaphenylene, polyparaphenylene vinylene, polythiophene, polyfuran, polypyrrole, polyselenophene, polyisothianaphthene, polyphenylene sulfide, polyacetylene, polypyridyl vinylene and polyazine, each of which may be substituted. Only a single conductive polymer may be used or a plurality of conductive polymers may be used in accordance with the purpose. In an embodiment, a mixture of a conductive polymer and a nonconductive polymer is used which has such a mixing ratio that a desired conductivity is attained. In another embodiment, a copolymer of a conductive monomer and a nonconductive monomer is used which has a desired conductivity.

The method of forming a conductive polymer layer with such a conductive polymer is not particularly restricted. In order to form a uniform thin film, the following method is preferable which uses a conductive monomer.

The method comprises: immersing the substrate having the graft polymer region in a solution including a polymerization catalyst such as potassium persulfate or iron sulfate (III) and a compound having a polymerization initiation capability; and gradually delivering a monomer capable of forming a conductive polymer such as 3, 4-ethylene dioxythiophene by drops into the solution while stirring the solution. In this method, the polar group (hydrophilic group) on the graft polymer is provided with the polymerization catalyst and/or polymerization initiating ability is imparted to the polar group. The polar group and the monomer interact with each other and the monomer is strongly adsorbed by the polar group. The polymerization of the monomer proceeds to form a very thin film of the conductive polymer on the graft polymer region on the support. The thin film is a conductive polymer layer.

In the method of the invention, the conductive monomer interacts with the functional group in the graft polymer region by an electrostatic force or by a polarity force and strongly adhered to the hydrophilic region. Accordingly, the resultant polymer film interacts strongly with the graft polymer region. Therefore, even a thin film has a sufficient strength against scrubbing or scratching.

Furthermore, when the conductive polymer has a positive charge and the polar group (hydrophilic group) on the graft polymer has a negative charge, the polar group (hydrophilic group) absorbed by the conductive polymer works as a dopant; accordingly, the conductivity of the conductive pattern can be further improved. In an embodiment, the substances of the conductive polymer and the graft polymer are selected such that the above effect can be obtained. Specifically, for instance, if the hydrophilic group is styrene sulfonic acid and the conductive polymer is derived from thiophene, then polythiophene with a sulfonic acid group (sulfo group) as a counter anion exists at the interface between the graft polymer region and the conductive polymer layer because of the interaction between the conductive polymer and the hydrophilic group. The counter anion functions as a dopant for the conductive polymer.

The film thickness of the conductive polymer layer formed on the hydrophilic region is not particularly limited, and is preferably 0.01 to 10 µm, more preferably 0.1 to 5 µm. When the film thickness is in the range, sufficient conductivity and transparency can be attained. When the film thickness is 0.01 µm or less, in some cases, the conductivity is insufficient.

The conductive pattern (B') obtained by the method of the invention for forming a conductive pattern is excellent in the strength and durability. The conductive pattern is expected to be used in wide range of applications such as a high definition (high resolution) wiring board prepared by a single circuit formation process or a wiring board requiring a large area of conductivity region.

Furthermore, when a transparent film such as PET is used as a support, the conductive pattern can be used as a patterned transparent conductive film. The transparent conductive film may be used in a transparent electrode for a display, a light control device , a solar battery, a touch panel, and a transparent conductive film for other applications. The transparent conductive film is particularly useful as an electromagnetic wave shield filter attachable to a CRT or a plasma display. Since such an electromagnetic wave shield filter has to be highly conductive and transparent, the conductive substance is preferably disposed in lattice. The width of the lattice line is preferably 20 to 100 µm. The space between the neighboring lattice lines is preferably about 50 to about 600 µm. The lattice does not necessarily have a regular arrangement with straight lines, and may be formed with curved lattice lines.

According to the conductive patterned material (B) and conductive pattern forming method (B'), a further finer pattern having a line width of 10 µm or less can be formed by suitably selecting the exposure condition at the pattern exposure. Therefore, a metal wiring or metal particle adhesion region having an arbitrary pattern can be easily formed. The design of the conductive pattern is highly flexible and can be adapted to various purposes.

In the conductive pattern forming method (C'), after the graft polymer region is formed, i) a metal is deposited thereon by: applying a metal ion or a metal salt to the region, then reducing the metal ion or the metal ion in the salt. In the conductive pattern forming method (D'), after the graft polymer region is formed, ii) a conductive pattern is formed by: applying an electroless plating catalyst or a precursor thereof to the region, then conducting electroless plating to form a thin metal film. Hereinafter, these methods will be described in detail.

The conductive pattern forming method (C') comprises: applying a metal ion or a metal salt to the graft polymer region and reducing the metal ion or the metal ion in the salt. In this method, a functional group on the graft polymer such as a hydrophilic group adsorbs the metal ion or the metal salt, and then, the adsorbed metal ion or the like is reduced, resulting in deposition of pure metal on the graft polymer region. Depending on the deposition manner, a thin metal film or a metal particle adhesion layer including dispersed metal particles can be obtained.

### <Applying a metal ion or a metal salt>

The method for applying a metal ion or a metal salt may be suitably selected according to the compound constituting the graft polymer region. The graft polymer region is preferably a hydrophilic region from the viewpoint of adhesion of metal ions or the like thereto, and in such a case, the compound constituting the region is a hydrophilic compound.
The following methods (1) to (4) are examples of the method.
(1) This method is applicable if the graft polymer has an ionic group (polar group). The method comprises allowing the ionic group on the graft polymer to adsorb a metal ion.
(2) This method is applicable if the graft polymer includes a compound having a high affinity for the metal salt such as polyvinyl pyrrolidone. The method comprising impregnating the graft polymer region with a metal salt or a solution containing a metal salt.
(3) This method comprises immersing the graft polymer region in a solution containing a metal salt so as to impregnate the graft polymer region with the solution.
   In particular, the method (3) does not require the compound to have a specific character and is applicable to adhering a desired metal ion or metal salt to the graft polymer region.

The conductive pattern forming method (D') comprises: applying an electroless plating catalyst or a precursor thereof to the graft polymer region (interaction region); and then forming a patterned thin metal film by electroless plating.

In this method, the graft polymer having a functional group (i.e., polar group) that is capable of interacting with the electroless plating catalyst or the precursor thereof interacts with the electroless plating catalyst or the precursor thereof, and a thin metal film is formed by the subsequent electroless plating.

As a result, a metal (particle) film is formed. If a thin metal film (continuous film) is formed, the film constitutes a region having especially high conductivity. In the graft-polymer-free region, the metal ion, metal salt, and electroless plating catalyst (precursor) are not adsorbed or impregnated, and accordingly a non-conductive insulating region is formed instead of a metal (particle) film.

Hereinafter, the conductive pattern forming method (c') will be described in detail.

### <Applying a metal ion or a metal salt>

### [Metal ion and metal salt]

In the invention, the metal salt is not particularly limited as long as the metal salt can be dissolved in a solvent to form a metal ion and a base (negative ion) wherein the solvent is appropriate for being applied to the surface of the graft polymer region. For example, the metal salt may be M(NO₃)ₙ, MClₙ, M_{2/n}(SO₄) or M_{3/n}(PO₄) (M denotes a n-valent metal atom). The metal ion may be a metal ion formed by the dissociation of any of the above metal salts. Ag, Cu, Al, Ni, Co, Fe and Pd are examples of the metal. Ag is a preferable metal for forming a conductive film. Co is a preferable metal for forming a magnetic film.

Only a single kind of metal salt or metal ion may be used. Alternatively, a plurality of substances selected from metal salts and metal ions may be used. In an embodiment, a plurality of substances are mixed prior to use in order to obtain a desired conductivity.

### Method for applying the metal ion or metal salt

In an embodiment of the above method (1), the metal salt is dissolved in an appropriate solvent, and the solution is coated on the surface of the substrate having the graft polymer region. In another embodiment, the substrate with the graft polymer is immersed in the solution (containing the metal ion). When the solution is brought into contact with the surface of the substrate, the metal ion is ionically adsorbed by the ionic group. In order to allow the adsorption to occur sufficiently, the metal ion concentration or the metal salt concentration of the solution is preferably 1 to 50 % by mass, more preferably 10 to 30 % by mass. The contact time is preferably about 10 seconds to 24 hrs, more preferably about 1 min to about 180 min.

In an embodiment of the above method (2), the metal salt in the form of a particle is directly applied to the graft polymer region. In another embodiment, a dispersion liquid is prepared with a solvent appropriate for dispersing the metal salt and (i) the dispersion liquid is coated on the surface of the substrate having the graft polymer region, or (ii) the substrate having the graft polymer region is immersed in the dispersion liquid. When the graft polymer comprises hydrophilic compounds, the water retention property of the graft polymer region is very high. Owing to the high water retention property, the graft polymer region can be impregnated with the dispersion liquid including a dispersed metal salt. In order to sufficiently impregnate the graft polymer region with the dispersion liquid, the metal salt concentration of the dispersion liquid is preferably 1 to 50 % by mass, more preferably 10 to 30 % by mass. The contact time is preferably about 10 seconds to 24 hrs, more preferably about 1 min to about 180 min.

In an embodiment of the above method (3), a dispersion liquid or a solution of the metal salt is prepared by using a suitable solvent, and (i) the dispersion liquid or the solution is coated on the surface of the substrate having the hydrophilic graft polymer region, or (ii) the substrate having the hydrophilic graft polymer region is immersed in the dispersion liquid or the solution. As described above, since the hydrophilic graft polymer region has a high water retention property, the hydrophilic graft polymer region can be impregnated with the dispersion liquid or the solution. In order to sufficiently impregnate the hydrophilic graft polymer region with the dispersion liquid or the solution, the concentration of the metal salt in the dispersion liquid or the solution is preferably 1 to 50 % by mass, more preferably 10 to 30 % by mass. The contact time is preferably about 10 seconds to 24 hrs, more preferably about 1 min to about 180 min.

### <Formation of metal (particle) film>

### [Reducing agent]

In the method of the invention, the reducing agent for reducing the metal ion or the metal ion in the metal salt is not particularly limited as long as the reducing agent can reduce the metal ion or the metal ion in the metal salt to deposit metal. The reducing agent may be, for instance, a hypophosphite, tetrahydroborate or hydrazine.

The reducing agents can be appropriately selected in accordance with the metal salt or metal ion. If an aqueous solution of silver nitrate is applied to the graft polymer region, for example, sodium tetrahydroborate can be used as the reducing agent. If an aqueous solution of palladium dichloride is applied to the graft polymer region, hydrazine can be used as the reducing agent.

In an embodiment, after a metal ion or a metal salt is provided on the surface of the substrate having the graft polymer region, the substrate is washed with water so that free metal salt or metal ion is removed, then the substrate is immersed in water such as ion-exchanged water, then the reducing agent is added to the water. In another embodiment, an aqueous solution of the reducing agent having a predetermined concentration is directly coated or dropped on the surface of the substrate. The amount of the reducing agent to be added is preferably an excessive amount relative to the amount of the metal ion. In an embodiment, the amount of the reducing agent is equivalent to the amount of the metal ion or higher. In another embodiment, the amount of the reducing agent is at least 10 times the amount which is equivalent to the amount of the metal ion.

The metal (particle) film formed by the addition of the reducing agent is uniform and has high strength. The presence of the metal (particle) film can be confirmed by visual observation of the metallic luster on the surface. Its structure can be confirmed by an observation with a transmission electron microscope or an AFM (atomic force microscope). The film thickness of the metal (particle) film can be easily measured by a standard method such as a method of observing a section with an electron microscope.

### [Relationship between the polarity of the polar group on the graft polymer and the metal ion or the metal salt]

In an embodiment in which the graft polymer has a functional group having a negative charge, a metal ion having a positive electric charge is provided on the graft polymer region and adsorbed by the functional group. In the embodiment, the adsorbed metal ion is reduced to deposit, thus an elemental metal deposition region can be formed
wherein the elemental metal may be in the form of a metal film or a metal particle..

### [Relationship between the polarity of the hydrophilic group on the graft polymer and the metal ion or the metal salt]

When the graft polymer has an anionic functional group such as a carboxyl group, a sulfonic group, or a phosphonic group as the hydrophilic group, the graft polymer region in the pattern selectively has a negative charge. By adhering thereto a metal ion having a positive charge and reducing the metal ion, a metal (particle) film region (for example, wiring) can be formed.

When the graft polymer has, as a hydrophilic functional group, a cationic group such as an ammonium group described in JP-A No. 10-296895, the graft polymer region in the pattern selectively has a positive charge. In that case, a metal (particle) film region (such as wiring) can be formed by impregnating the graft polymer region with a solution including a metal salt and reducing the metal ion in the solution.

From a viewpoint of the durability, the metal ion is preferably adhered to the polar group (hydrophilic group) on the graft polymer in the maximum amount which can be adhered (adsorbed).

It is confirmed that the metal particles are dispersed densely in the graft polymer layer in the graft polymer region of the conductive pattern obtained by the conductive pattern forming method (C'), when the surface and section of the region are observed with a SEM or an AFM.
The particle size of the metal particles is generally 1 nm to 1 µm.

The metal thin film pattern prepared by the above method can be used as a conductive pattern without any further treatment if the metal particles are densely dispersed in the conductive pattern so that a metal thin film is observable. However, in order to obtain a higher conductivity, heat treatment is preferably conducted as described below.

The heating temperature in the heat treatment is preferably 100 °C or higher, more preferably 150 °C or higher, still more preferably 200 °C or higher. The heating temperature is preferably 400 °C or lower, in consideration of the treatment efficiency and the dimensional stability of the substrate. The heating time is preferably 10 min or longer, and more preferably about 30 min to about 60 min. By the heat treatment, some neighboring metal particles are partially fused to each other to improve the conductivity.

Hereinafter, the conductive pattern forming method (D') will be described in detail.

### <Applying an electroless plating catalyst or a precursor thereof >

In the method (D'), an electroless plating catalyst or the precursor thereof is applied to the graft polymer region (interaction region).

### <Electroless plating catalyst>

The electroless plating catalyst is generally a 0-valent metal such as Pd, Ag, Cu, Ni, Al, Fe or Co. In the invention, Pd and Ag are preferable because of their handling easiness and high catalytic power. The method for fixing the 0-valent metal onto the graft pattern (interacting region) may be, for instance, a method comprising providing the interaction region with a metal colloid having such an electric charge as to interact with the interacting group on the graft pattern. In general, the metal colloid can be prepared by reducing metal ion in a solution including a charged surfactant or a charged protective agent. The electric charge of the metal colloid can be controlled by the kind of surfactant or the kind of protective agent. The metal colloid provided onto the interaction region is selectively adsorbed by the interaction region.

### <Electroless plating catalyst precursor>

The electroless plating catalyst precursor is not particularly limited as long as the precursor becomes an electroless plating catalyst by a chemical reaction. Generally, the precursor is a metal ion of any of the 0-valent metals mentioned above as the electroless plating catalyst. The metal ion, which is a precursor, is reduced to become a 0-valent metal, which is an electroless plating catalyst. The metal ion adhered to the interaction region may be reduced to become a 0-valent metal before immersed in an electroless plating bath, or may be immersed in an electroless plating bath so as to be converted to a metal (electroless plating catalyst) by a reducing agent in the bath.

In an embodiment, the metal ion is provided onto the graft polymer region (interaction region) in the state of a metal salt. The metal salt is not particularly limited as long as the metal salt can be dissolved in an appropriate solvent to dissociate into a metal ion and a base (negative ion). The metal salt may be M(NO₃)ₙ, MClₙ, M_{2/n}(SO₄) or M_{3/n}(PO₄) (M denotes an n-valent metal atom). The metal ion may be an ion generated by a dissociation of any of the above metal salts. Examples thereof include Ag ion, Cu ion, Al ion, Ni ion, Co ion, Fe ion and Pd ion. Ag ion and Pd ion have high catalytic power.

The method for providing the metal colloid or the metal salt onto the graft polymer region (interaction region), may be a method comprising: dispersing the metal colloid in a proper dispersion medium or dissolving the metal salt in a proper solvent to prepare a solution including dissociated metal ion; and coating the interaction region with any of the solution or the dispersion liquid, or immersing the substrate having the graft pattern in the solution or the dispersion liquid. The metal ion can be adsorbed to the interacting groups in the interaction region by an ion-ion interaction or a dipole-ion interaction, or the interaction region can be impregnated with the metal ion. In order to sufficiently carry out the adsorption or impregnation, the metal ion concentration or metal salt concentration of the solution to be provided onto the area is preferably 0.01 to 50 % by mass, more preferably 0.1 to 30 % by mass. The contact time is preferably about 1 min to about 24 hrs, more preferably about 5 min to about 1 hr.

### [electroless plating]

The electroless plating is applied to the substrate having the electroless plating catalyst or precursor thereof on the interaction region, so that a metal film is formed in a pattern. When the electroless plating is applied as described below, a dense metal film is formed on the graft pattern in accordance with the graft pattern. As a result, the resultant metal pattern has an excellent conductivity and adhesiveness.

### <Electroless plating>

The electroless plating means an operation comprising allowing a metal to deposit through a chemical reaction by using a solution in which an ion of the metal is dissolved. In an embodiment, the substrate having the electroless plating catalyst in a pattern is washed with water to remove free electroless plating catalyst (metal), then the substrate is immersed in an electroless plating bath. The electroless plating bath used in the embodiment may be a generally known electroless plating bath.

In another embodiment, the substrate having the electroless plating catalyst precursor in a pattern is washed with water to remove free electroless plating catalyst precursor (such as metal salt), then immersed in an electroless plating bath. In the embodiment, in the electroless plating bath, the precursor is reduced then an electroless plating proceeds. The electroless plating bath used in the embodiment may be a generally known electroless plating bath.

A general electroless plating bath include (1) a metal ion for plating, (2) a reducing agent, and (3) an additive (stabilizing agent) that improves the stability of the metal ion. In the plating bath, known additives such as a stabilizing agent for the plating bath may be further included.

The metal used in the electroless plating bath may be, for example, copper, tin, lead, nickel, gold, palladium or rhodium. From the viewpoint of the conductivity, copper and gold are preferable.

The most suitable reducing agent and additives depend on the metal type. For instance, a copper electroless plating bath may include Cu(SO₄)₂ as a copper salt, HCOH as a reducing agent, and a chelate agent such as EDTA or Rochelle salt which stabilizes copper ion as an additive. A CoNiP plating bath may include cobalt sulfate and nickel sulfate as metal salts, sodium hypophosphite as a reducing agent, and sodium malonate, sodium malate and sodium succinate as complexing agents. A palladium electroless plating bath may include (Pd(NH₃)₄)Cl₂ as a metal ion, NH₃ and H₂NNH₂ as reducing agents and EDTA as a stabilizing agent. These plating baths may further include other ingredients.

The film thickness of the metal film formed as described above can be controlled by factors such as the concentration of the metal salt or metal ion in the plating bath, the immersing time in the plating bath and the temperature of the plating bath. From the viewpoint of the conductivity, the film thickness is preferably 0.5 µm or larger, more preferably 3 µm or larger. The immersing time in the plating bath is preferably about 1 min to about 3 hr, more preferably about 1 min to about 1 hr.

It is confirmed by a sectional observation with SEM that particles of the electroless plating catalyst and the plating metal are densely dispersed in the graft polymer layer and relatively large particles are present thereon. The interface is in a hybrid-state of the graft polymer and the particles; accordingly, the adhesiveness is excellent even when difference in level between the interface of the substrate (may be an organic substrate) and the interface of the inorganic substance (electroless plating catalyst or plating metal) is 100 nm or less.

### [Electroplating]

In the conductive pattern formation method (D'), after the electroless plating is conducted, an additional electroplating may be conducted. In the electroplating, the metal film obtained by the electroless plating is used as an electrode. Therefore, the metal film pattern having excellent adhesiveness to the substrate can be used as a base for the additional electroplating, and another metal film having an arbitrary thickness can be easily formed thereon. When the additional electroplating is conducted, a conductive pattern having a thickness which is suitable for the application can be obtained; accordingly, the conductive pattern according to the invention can be applied to various applications such as a wiring pattern.

The method for the electroplating may be a known method. The metal used in the electroplating may be copper, chrome, lead, nickel, gold, silver, tin or zinc. From the viewpoint of the conductivity, copper, gold and silver are preferable and copper is more preferable.

The film thickness of the metal film obtained by the electroplating may be controlled in accordance with the application. The film thickness can be controlled by controlling factors such as the metal concentration in the plating bath, the immersing time, or the current density. The film thickness used in a general electric wiring or the like is, from a viewpoint of the conductivity, preferably 0.3 µm or larger, more preferably 3 µm or larger.

The conductive patterned material (C) is a conductive patterned material obtained by the conductive pattern formation method (C') of the invention. The conductive patterned material (D) is a conductive patterned material obtained by the conductive pattern formation method (D') of the invention.

The conductive patterned material (C) is prepared by: subjecting the substrate surface having a compound having a photopolymerization initiation site and a substrate binding site bound to the substrate, to a pattern exposure so as to inactivate the photopolymerization initiation site in the exposed region; bringing a radical polymerizable unsaturated compound into contact with the surface of the substrate; and subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; providing a metal ion or a metal salt to the graft polymer region; and reducing the metal ion or the metal ion in the metal salt to deposit the metal.

The conductive patterned material is prepared by: subjecting the substrate surface having a compound having a photopolymerization initiation site and a substrate binding site bound to the substrate, to a pattern exposure so as to inactivate the photopolymerization initiation site in the exposed region; bringing a radical polymerizable unsaturated compound into contact with the surface of the substrate; and subjecting the substrate surface to an entire-surface exposure so as to cause a photochemical cleavage of the photopolymerization initiation site remaining in the region which was not exposed in the pattern exposure, to initiate a radical polymerization, and to generate a graft polymer; providing an electroless plating catalyst or a precursor thereof to the graft polymer region; and conducting an electroless plating to form a patterned thin metal film.

In the invention, the polymerization initiation site preferably includes a bond selected from the group consisting of a C-C bond, C-N bond, C-O bond, C-Cl bond, N-O bond, and S-N bond.

The conductive patterned materials (C) and (D) of the invention can have, on a surface thereof, a high-definition durable dense metal (particle) pattern. Such a patterned material can be prepared by simple processes of the method of the invention. The conductive patterned material of the invention can be expected to be used in a wide range of applications such as fine electric wiring, high density magnetic discs, magnetic heads, magnetic tapes, magnetic sheets and magnetic discs. The patterned materials can be used also in various circuit formation applications. Since a fine conductive region can be formed by suitably selecting the pattern formation device, the patterned materials are expected to be used for wide applications including circuit formations of such as micro-machines and VLSIs.

Furthermore, if a transparent film such as PET is used as the support, the patterned material can be used as a patterned transparent conductive film. Examples of the application of such transparent conductive film include transparent electrodes for displays, light control devices, solar batteries, touch panels, and other transparent conductive films. The transparent conductive film is particularly useful as electromagnetic wave shield filters to be attached to CRTs or plasma displays. Since such an electromagnetic wave shield filter has to be highly conductive and transparent, the metal (particle) film is preferably disposed in lattice. The width of the lattice line is preferably 20 to 100 µm. The space between the neighboring lattice lines is preferably about 50 to about 600 µm. The lattice does not necessarily have a regular arrangement with straight lines, but may be formed with curved lattice lines.

According to the invention, a further finer pattern having a line width of 10 µm or less can be easily formed by suitably selecting the exposure condition for the pattern exposure. Therefore, a metal wiring or metal particle adhesion region having an arbitrary pattern can be easily formed. The design of the conductive pattern is highly flexible and can be adapted to various purposes.

### EXAMPLES

Hereinafter, the present invention will be described more specifically with reference to Examples, but the Examples should not be construed as limiting the invention.

### (Synthesis example 1: Synthesis of compound A)

The exemplary compound 1 may be prepared through the following two steps. The scheme of each step will be described.

### 1. Step 1 (synthesisi of compound α)

In a mixed solvent of 50 g of DMAc and 50 g of THF, 24.5 g (0.12 mol) of 1-hydroxycyclohexylphenylketone was dissolved, and 7.2 g (0.18 mol) of NaH (60% in oil) was added gradually to the mixture in an ice bath. To the solution, 44.2 g (0.18 mol) of 11-bromo-1-undecene (95%) was added dropwise and allowed to react at room temperature. The reaction was completed in 1 hour. The reaction solution was poured into ice water and extracted with ethyl acetate, to give a mixture including the compound a shown below in the form of yellowish solution. The mixture (37 g) was dissolved in 370 ml of acetonitrile and 7.4 g of water was added thereto. Then, 1.85 g of p-toluenesulfonic acid monohydrate was added thereto, and the mixture was stirred at room temperature for 20 minutes. The organic phase was extracted with ethyl acetate, and the solvent in the extract was removed by distillation. The compound a was isolated by column chromatography (filler: Wako Gel C-200, elution solvent: ethyl acetate/hexane = 1/80).
The scheme of the synthesis is shown below: 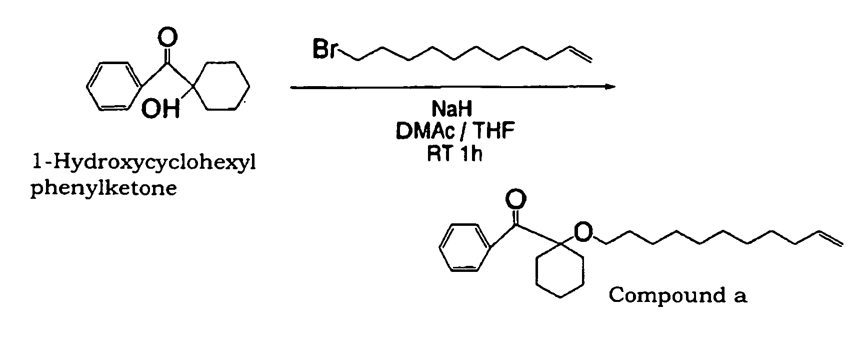 ¹H NMR (300 MHz, CDCl₃)
δ-1.2-1.8 (mb, 24H), 2.0 (q, 2H), 3.2 (t, J=6.6, 2H), 4.9-5.0 (m, 2H) 5.8 (ddt, J=24.4, J=10.5, J=6.6, 1H), 7.4 (t, J=7.4, 2H), 7.5(t, J=7.4, 1H), 8.3 (d, 1H)

### 2. Step 2 (synthesis of compound A by hydrosilylation of compound α)

To 5.0 g (0.014 mol) of compound a, two drops of Speir catalyst (H₂PtCl₆-6H₂O/2-PrOH, 0.1 mol/l) was added and then 2.8 g (0.021 mol) of trichlorosilane was added dropwise thereto in an ice bath and the mixture was stirred. After 1 hour, 1.6 g (0.012 mol) of trichlorosilane was further added dropwise thereto and the mixture was allowed to warm to room temperature. The reaction was completed in 3 hours. After the reaction, unreacted trichlorosilane was removed under reduced pressure, so that the compound A was obtained.
The scheme of the synthesis is shown below: 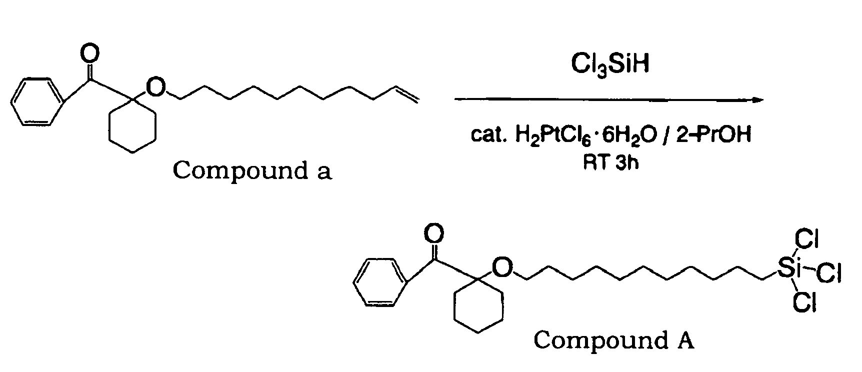 ¹H NMR (300 MHz CDCl₃)
δ =1.2-1.8 (m, 30H), 3.2 (t, J=6.3, 2H), 7.3-7.7 (m, 3H), 8.3 (d, 2H) (Synthesis example 2: Synthesis of hydrophilic polymer P having a polymerizable group)

18 g of polyacrylic acid (average molecular weight: 25,000) was dissolved in 300 g of DMAc (dimethylacetamide). Then, 0.41 g of hydroquinone, 19.4 g of 2-methacryloyloxyethyl isocyanate, 0.25 g of dibutyl tin dilaurate were added thereto, and the mixture was allowed to react at 65°C for 4 hours. The acid value of the obtained polymer was 7.02 meq/g. The carboxyl groups were neutralized with aqueous 1 mol/l sodium hydroxide solution, and the polymer was precipitated by addition of ethyl acetate. The precipitate was washed well, to give a hydrophilic polymer P having a polymerizable group.

### [Example 1]

### (binding photocleavable compound)

A glass substrate (manufactured by Nippon Sheet Glass Co., Ltd.) was immersed in piranha solution (1/1 vol. mixed solution of sulfuric acid and 30% hydrogen peroxide) overnight and then washed with pure water. The substrate was immersed in a dehydrated toluene solution containing 12.5% by mass of compound A in a separable flask for 1 hour, wherein the air in the flask had been replaced with nitrogen before the immersion. The substrate was taken out of the flask, and washed with toluene, then with acetone, then with pure water. The obtained substrate, to which the compound A is bound, will be referred to as "substrate A1".

### (Deactivating polymerization initiating ability)

One face of the substrate A1 was pattern-exposed with an exposure machine (UVX-02516S1LP01, manufactured by Ushio Inc.) for 1 minute through a pattern mask (NC-1, manufactured by Toppan Printing Co.) held closely to the substrate by a clip. The pattern-exposed substrate will be referred to as substrate B1.

### (Formation of graft polymer)

Hydrophilic polymer P (0.5g) was dissolved in a mixed solvent of 4.0 g of pure water and 2.0 g of acetonitrile, to give a coating solution for forming the graft polymer. The coating solution was applied onto the pattern-exposed face of substrate B1 by a spin coater. The spin coater was rotated first at 300 rpm for 5 seconds, and then at 1,000 rpm for 20 seconds. The substrate B1 after the application was dried at 100°C for 2 minutes. The dry thickness of the coated layer for forming the graft polymer was 2 µm.

The entire surface of the substrate having the layer for forming the graft polymer layer was subjected to exposure with an exposure machine (UVX-02516S1LP01, manufactured by Ushio Inc.) for 5 minutes. The exposed face was then washed thoroughly with pure water. In this manner, a pattern C1 was formed.

### [Example 2]

### (Binding photocleavable compound)

A PET film (biaxially-drawn polyethylene terephthalate film) having a thickness of 188 µm was prepared whose one face had been previously subjected to a corona treatment. The PET film was cut into a piece having a size of 5 cmx5 cm, and the piece (substrate) was immersed in a dehydrated toluene solution containing 12.5% by mass of compound A in a separable flask for 1 hour, wherein the air in the flask had been replaced with nitrogen before the immersion. The substrate was taken out of the flask, and washed with toluene, then with acetone, then with pure water. The substrate, to which the compound A was bound, will be referred to as substrate A2.

### (Deactivating polymerization initiating ability)

One face of substrate A2 having the compound A1 was pattern-exposed in the same manner as in Example 1. The substrate thus processed will be referred to as substrate B2.

### (Formation of graft polymer)

1.0 ml of a 20% aqueous acrylic acid solution was provided dropwise onto the pattern-exposed face of substrate B2, and a quartz glass was placed thereon, so that a layer of the aqueous acrylic acid solution was sandwiched between the PET substrate (substrate A2) and the quartz glass.

The pattern-exposed face of the substrate was subjected to entire-suface exposure in the same manner as in Example 1. The exposed face was then washed thoroughly with pure water. In this manner, a pattern C2 was formed.

### <Examination and evaluation of patterns>

The patterns C1 and C2 obtained in Examples 1 and 2 were examined according to the following examination methods (1) and (2).

### [Examination method (1)]

Patterns C1 and C2 were visually observed by using an atom force microscope AFM (NANOPICS 1000, manufactured by Seiko Instruments Inc., DFM cantilever). The minimum line width of the resolvable line and space of each sample is shown in Table 1.

### [Examination method (2)]

The substrates having patterns C1 and C2 were immersed in an aqueous 0.1% methylene blue solution and then washed with pure water. Each pattern was then examined by an optical microscope. The minimum width of the resolvable line and space of each sample is shown in Table 1.

**Table 1**

| | Pattern | Examination method (1) | Examination method (2) |
|---|---|---|---|
| EXAMPLE 1 | C1 | 7µm | 7µm |
| EXAMPLE 2 | C2 | 8µm | 8µm |

As shown in Table 1, it was possible to easily form a fine graft polymer pattern having a line and space of 10 µm or less in Examples 1 and 2, in which the patterns are formed according to the pattern forming method of the invention.

### [EXAMPLE 3]

### (Adhesion of conductive material)

The substrate having the pattern C1 described in Example 1 was immersed in a positively charged Ag particle dispersion liquid obtained as described below. Then, the surface thereof was washed thoroughly with running water so as to remove excessive particle dispersion. A conductive patterned material D1 was obtained in this way wherein the conductive patterned material D1 has adsorbed Ag particles only on the graft polymer region.

### <Preparation of Ag particle dispersion>

3 g of bis(1,1-trimethylammoniumdecanoylaminoethyl)disulfide was added to 50 ml of an ethanol solution of silver perchlorate (5 mmol/l), and 30 ml of sodium borohydride solution (0.4 mol/l) was gradually added to the mixture while the mixture was stirred vigorously, so that the Ag ions were reduced. In this way, a dispersion liquid of silver particles coated with the quaternary ammonium salt was obtained. The average diameter of the silver particles, as determined by an electron microscope, was 5 nm.

### <Examination of conductive pattern>

The surface of conductive patterned material D1 thus obtained was observed by a transmission electron microscope (JEOL JEM-200Cx) at a magnification of 100,000. By the observation, it was confirmed that fine surface irregularity was formed by the Ag particles adhered only to the graft polymer region. It was also confirmed that fine wiring having a line width of 8 µm and a line spacing of 8 µm was formed on the conductive patterned material D1, wherein the line spacing refers to the distance from the edge of one line to the adjacent edge of the next line.

### <Evaluation of stability of conductivity>

The surface conductivity of the Ag particle region in the pattern thus obtained was determined to be 10 Ω/sq by using LORESTA-FP (manufactured by Mitsubishi Chemical Co., Ltd.) according to four-probe method. The transmittance of the entire surface of the patterned film was also measured and found to be 58%. The results showed that a conductive pattern with high transparency and superior conductivity was formed.

### [Example 4]

### (Adhesion of conductive material)

The substrate having the pattern C2 described in Example 2 was immersed in the positively charged Ag particle dispersion in the same manner as in Example 3, and the surface thereof was washed thoroughly with running water to remove excessive particle dispersion, so that a conductive patterned material D2 was obtained.

### <Examination of conductive pattern>

The surface of conductive patterned material D2 having adsorbed particles was observed by a transmission electron microscope (JEOL JEM-200Cx) at a magnification of 100,000. By the observation, it was confirmed that fine surface irregularity was formed by the Ag particles adhered only to the graft polymer region. It was also confirmed that fine wiring having a line width of 8 µm and a line spacing of 8 µm was formed on the conductive patterned material D2, wherein the line spacing refers to the distance from the edge of one line to the adjacent edge of the next line.

### <Evaluation of conductivity stability>

The surface conductivity of the Ag particle region in the pattern thus obtained was determined to be 20 Ω/sq by using LORESTA-FP (manufactured by Mitsubishi Chemical Co., Ltd.) according to four-probe method. The transmittance of the entire surface of the patterned film was also measured and found to be 58%. The results showed that a conductive pattern with high transparency and superior conductivity was formed.

### [Example 5]

### (Binding photocleavable compound)

An ITO-deposited glass substrate (manufactured by Nippon Sheet Glass Co., Ltd., surface resistivity: 10Ω/sq, product No.: 49J183) was washed by ultrasonic cleaning with isopropyl alcohol, then with acetone, then with methanol, and then with pure water, the washing time for each washing being at least 5 minutes. Then, the substrate was dried by blowing a nitrogen gas to the substrate. The substrate was immersed in a dehydrated toluene solution containing 12.5% by mass of compound A in a separable flask for 1 hour to overnight, wherein the air in the flask had been replaced with nitrogen prior to the immersion. The substrate was taken out of the flask and with toluene, then with acetone, then with pure water. The obtained substrate to which the compound A was bound will be referred to as substrate A3.

### (Inactivating polymerization initiating ability)

One face of the substrate A3 is pattern-exposed in the same manner as in Example 1. The substrate thus processed will be referred to as substrate B3.

### (Formation of graft polymer)

A layer for forming the graft polymer was provided on the substrate B3 in the same manner as in Example 1, by using the coating solution for forming the graft polymer, and the entire surface was exposed to form a pattern C3.

### (Adhesion of conductive material)

The substrate having the pattern C3 was immersed in the positively charged Ag particle dispersion liquid in the same manner as in Example 3, and the surface thereof was then washed thoroughly with running water to remove excessive particle dispersion, so that a conductivity pattern D3 was obtained.

### <Examination of conductive pattern>

The surface of conductive patterned material D3 having adsorbed particles was observed by a transmission electron microscope (JEOL JEM-200Cx) at a magnification of 100,000. By the observation, it was confirmed that fine surface irregularity was formed by the Ag particles adhered only to the graft polymer region. It was also confirmed that fine wiring having a line width of 8 µm and a line spacing of 8 µm was formed on the conductive patterned material D3, wherein the line spacing refers to the distance from the edge of one line to the adjacent edge of the next line.

### <Evaluation of conductivity stability>

The surface conductivity of the Ag particle region in the pattern thus obtained was determined to be 15 Ω/sq by using LORESTA-FP (manufactured by Mitsubishi Chemical Co., Ltd.) according to four-probe method. The transmittance of the entire surface of the patterned film was also measured and found to be 58%. The results showed that a conductive pattern with high transparency and superior conductivity was formed.

### [Examples 6 to 8]

Each of the substrates prepared in Examples 1, 2, and 5 having patterns C1 to C3 was immersed in a solution obtained by mixing 1.23 g of sodium anthraquinone-2-sulfonate monohydrate, 7.20 g of sodium 5-sulfosalicylate monohydrate, 4.38 g of iron trichloride hexahydrate, and 125 ml of water. Then, a solution of 0.75 ml of pyrrole in 125 ml of water was further added to the solution while the solution was stirred. One hour later, the substrate was taken out of the flask, and washed with water and then with acetone. In this way, each of conductive patterned materials D4 to D6 of Examples 6 to 8 was obtained which has a polypyrrole film (a conductive polymer layer) on the substrate surface. The surface of each of the conductive patterned materials D4 to D6 was observed in the same manner as in Example 3 by using a transmission electron microscope. As a result, it was confirmed that on each of the conductive patterned materials D4 to D6, fine wiring having a line width of 8 µm and a line spacing of 8 µm was formed, wherein the line spacing refers to the distance from the edge of one line to the adjacent edge of the next line.

### <Evaluation>

The stability of the conductivity of each of the conductive patterns D4 to D 6 was evaluated in the same manner as in Example 3. As a result, the surface conductivities of the conductive polymer layers of conductive patterns D4 to D6 were found to be respectively 350Ω/sq, 100Ω/sq, and 150Ω/sq. The results indicated that conductive patterns superior in conductivity were formed.

### <Evaluation of durability>

The surfaces of the conductive patterns D1, D2, and D4 obtained in Examples 3,4, and 6 were rubbed 20 reciprocating strokes with a cloth moistened with water (BEMCOT, manufactured by Asahi Kasei Corp.) by hand. After the rubbing, the surfaces were observed in the same manner as described above by using a transmission electron microscope (JEOL JEM-200CX) at a magnification of 100,000. As a result, it was confirmed that there was fine surface irregularity formed by the Ag particles adhered only to the unexposed region, similarly to the surfaces before the rubbing. The surface conductivity thereof was also measured according to the same method as in the above evaluation of the stability of the conductivity. It was found that there was no difference between the values before and after the rubbing.

The results of Examples 3 to 8 confirm that the conductive patterned materials of the invention obtained by the conductive pattern forming method of the invention are capable of possessing fine conductive patterns regardless of whether the conductive material is a conductive particle or a conductive polymer. The method of the invention enables easy production of conductive patterns with stable conductivity. The conductivity of the conductive patterns has excellent durability.

### (EXAMPLE 9)

### (Formation of metal (particle) film)

The substrate having the pattern C1 described in Example 1 was immersed in an aqueous solution containing 15% by mass silver nitrate (manufactured by Wako Pure Chemical Industries) for 12 hours and then washed with distilled water. The substrate was then immersed in 100 ml of distilled water, and 30 ml of 0.2 mol/l sodium tetrahydroborate solution was added dropwise into the distilled water, so that the adsorbed silver ion were reduced. As a result, a uniform Ag metal film (metal (particle) film) was formed on the surface of the pattern C1. The Ag metal film had a thickness of 0.1 µm. In this manner, a conductive patterned material E1 having the Ag (particle) film thereon was obtained.

Electron microscopic observation of the surface of the conductive patterned material E1 confirmed the formation of a excellent conductive pattern having a line width of 8 µm and a line spacing of 8 µm, wherein the line spacing refers to the distance from the edge of one line to the adjacent edge of the next line.

### (EXAMPLE 10)

### (Formation of metal (particle) film)

The substrate having the pattern C2 described in Example 2 was processed in the same manner as in Example 9, to give a substrate having a uniform Ag metal film (metal (particle) film) on the surface of the pattern C2. The thickness of the formed Ag metal film was 0.1 µm. In this manner, a conductive patterned material E2 having the Ag (particle) film was obtained.

Electron microscopic observation of the surface of the conductive patterned material E2 confirmed the formation of a excellent conductive pattern having a line width of 8 µm and a line spacing of 8 µm, wherein the line spacing refers to the distance from the edge of one line to the adjacent edge of the next line.

### (EXAMPLE 11)

### (Formation of metal (particle) film)

The substrate having the pattern C3 described in Example 5 was processed in the same manner as in Example 9, to give a substrate having a uniform Ag metal film (metal (particle) film) on the surface of the pattern C3. The thickness of the formed Ag metal film was 0.1 µm. In this manner, a conductive patterned material E3 having the Ag (particle) film was obtained.

Electron microscopic observation of the surface of the conductive patterned material E3 confirmed the formation of a excellent conductive pattern having a line width of 8 µm and a line spacing of 8 µm, wherein the line spacing refers to the distance from the edge of one line to the adjacent edge of the next line.

### <Evaluation of conductivity>

The surface conductivities of the conductive patterned regions of the conductive patterned materials E1, E2 and E3 were determined, according to four-probe method by using LORESTA-FP (manufactured by Mitsubishi Chemical Co., Ltd.). The results are as follows:
Conductive patterned material E 1: 10 Ω/sq
Conductive patterned material E2: 15 Ω/sq
Conductive patterned material E3: 20 Ω/sq

### <Evaluation of thin metal film>

### 1. Film strength (adhesiveness)

The film adhesiveness of each of the conductive patterned materials E1, E2 and E3 was determined by a cross-cut tape method in accordance with JIS (Japanese Industrial Standards) 5400 (which is incorporated herein by reference). When the peeling test of peeling a tape from cross-cut grids was conducted, no grid was peeled in any of the conductive patterned material E1, E2, and E3; that is, the adhesiveness of the metal thin film to the substrate was found to be excellent.

### 2. Durability

The surface of each of the conductive patterned materials E1, E2 and E3 was rubbed 30 reciprocating strokes with a cloth moistened with water (BEMCOT, manufactured by Asahi Kasei Corp.) by hand. Visual observation of the surface after the rubbing confirmed that there was no exfoliation of the metal (particle) film in any of the conductive patterned materials E1, E2 and E3. In addition, the film adhesiveness of the samples after the rubbing was evaluated by the cross-cut tape method in the same manner as described above. As a result, no grid exfoliation was observed in any of the conductive patterned materials E1, E2 and E3. Therefore, it was confirmed that the adhesiveness between the metal (particle) film and the substrate did not deteriorate even after the rubbing and that the samples had excellent durability.

### (Examples 12 to 14)

Substrates having the patterns C1 to C3 obtained in the same manner as in Examples 1, 2, and 5 were immersed in an aqueous 0.1% by mass palladium nitrate solution (manufactured by Wako Pure Chemical Industries) for 1 hour and washed with distilled water. Then, they were immersed in an electroless plating solution having the following composition for 20 minutes, to give respectively conductive patterned materials E4 to E6.

### <Composition of electroless plating solution>

- OPC Copper H T1 (manufactured by Okuno Chemical Industries Co., Ltd.) 6 mL
- OPC Copper H T2 (manufactured by Okuno Chemical Industries Co., Ltd.) 1.2 mL
- OPC Copper H T3 (manufactured by Okuno Chemical Industries Co., Ltd.) 10 mL
- Water 83 mL

The surface of each of the conductive patterned materials E4 to E6 was observed by using an optical microscope (manufactured by Nikon Corp., OPTI PHOTO-2). As a result, a favorable pattern having a line width of 8 µm and a line spacing of 8 µm was observed on each of the conductive patterned materials E4 to E6, wherein the line spacing refers to the distance from the edge of one line to the adjacent edge of the next line.

### (Evaluation of conductivity)

The surface conductivity of the conductive patterned region of Cu thin film on each of the conductive patterned materials E4 to E6 was determined in the same manner as in Example 9. The results are as follows:
Conductive patterned material E4: 7Ω/sq
Conductive patterned material E5: 5Ω/sq
Conductive patterned material E6: 8Ω/sq

### (Evaluation of metal film)

### 1. Film strength (adhesiveness)

In the same manner as in Examples 9 to 11, the film adhesiveness of the conductive patterned materials E4 to E6 having Cu thin films thereon was evaluated. When the peeling test of peeling a tape from cross-cut grids was conducted, no grid was peeled in any of the conductive patterned material E4 to E6; that is, the adhesiveness of the conductive pattern to the substrate was found to be excellent.

The invention provide a high-resolution conductive patterned material superior in productivity, durability, and conductivity stability. The invention also provide a method superior for forming a high-resolution conductive pattern superior in durability and conductivity stability in a simple manner, the method having excellent productivity.

The invention further provides a conductive pattern-forming method suitable for preparing materials that requires formation of a pattern having high conductivity and fine resolution such as fine electric wiring boards and electromagnetic shields. The invention further provides a conductive patterned material satisfying such requirements.

The invention further provides a method for forming a conductive pattern, the method comprising forming a metal particle dispersion layer with excellent adhesiveness and durability. In the metal particle dispersion layer, metal particles are dispersed at high density in a fine high-resolution pattern. The method has a high productivity and simple processes. The invention further provides a conductive patterned material having the properties as recited above.

The conductive pattern of the invention and metal particle patterned material are applicable to a wide variety of applications, including materials demanding high conductivity and circuits in desired patterns such as metal wiring materials and electromagnetic shields (for example, applications to circuits for micromachines and VLSI's), electromagnetic shield filters for CRTs and plasma displays, transparent electrodes for displays, optical devices, solar batteries, transparent conductive films for touch panels and the like, high-density magnetic discs, magnetic heads, magnetic tapes, magnetic sheets, magnetic materials for magnetics disc and other magnetic materials.

## Claims

1. A pattern-forming method comprising:
binding a compound (Q-Y) having a substrate binding site (Q) and a photopolymerisation initiation site (Y) capable of initiating radical polymerisation by photocleavage thereof to a surface of a substrate;
subjecting the surface to a pattern exposure to inactivate the photopolymerisation initiation site in the exposed region;
bringing a radical polymerisable unsaturated compound into contact with the surface; and
subjecting the surface to entire-surface exposure to light to cause a photochemical cleavage of the photopolymerisation initiation site (Y) remaining in the region which was not exposed in the pattern exposure,
wherein the cleavage of the photopolymerisation initiation site (Y) initiates radical polymerisation to form a graft polymer.

2. The pattern-forming method according to Claim 1, wherein the polymerisation initiation site (Y) includes a bond selected from C-C, C-N, C-O,C-C1, N-O and S-N.

3. The pattern-forming method according to Claim 1, further comprising the step of adhering a conductive material to the graft polymer to form a conductive pattern.

4. The pattern-forming method according to Claim 3, wherein the polymerisation initiation site includes a bond selected from C-C, C-N, C-O, C-Cl, N-O and S-N.

5. The pattern-forming method according to Claim 1, further comprising the step of adhering a metal ion or a metal salt to the graft polymer; and
depositing the metal by reducing the metal ion or the metal ion in the metal salt to form a conductive pattern.

6. The pattern-forming method according to Claim 5, wherein the polymerisation initiation site includes a bond selected from C-C, C-N, C-O, C-Cl, N-O and S-N.

7. The pattern-forming method according to Claim 1, further comprising the step of adhering an electroless plating catalyst or a precursor thereof to the graft polymer; and
forming a patterned thin metal film by electroless plating to form a conductive pattern.

8. The pattern-forming method according to Claim 7, wherein the polymerisation initiation site includes a bond selected from C-C, C-N, C-O, C-Cl, N-O and S-N.

9. The pattern-forming method according to Claim 7, further comprising conducting electroplating subsequent to the electroless plating.

10. The pattern-forming method according to Claim 7, further comprising the step of conducting electroplating on the thin metal film.

## Patentansprüche

1. Verfahren zur Herstellung eines Musters, welches folgendes umfasst:
Binden einer Verbindung (Q-Y) an eine Oberfläche eines Trägers, wobei die Verbindung eine Trägerbindungsstelle (Q) und eine Fotopolymerisationsstartstelle (Y), die in der Lage ist eine radikalische Polymerisation durch dessen Lichtspaltung zu starten, aufweist;
Unterwerfen der Oberfläche einer musterförmigen Belichtung, um die Fotopolymerisationsstartstellen in dem belichteten Bereich zu inaktivieren;
Kontaktieren der Oberfläche mit einer radikalisch polymerisierbaren ungesättigten Verbindung; und
Unterwerfen der Oberfläche einer gänzlichen Oberflächenbelichtung, um eine fotochemische Spaltung der Fotopolymerisationsstartstelle (Y) zu verursachen, welche in dem Bereich verblieben sind, der nicht bei der musterförmigen Belichtung belichtet wurde,
wobei die Spaltung der Fotopolymerisationsstartstelle (Y) eine radikalische Polymerisation zur Bildung eines Pfropfpolymers startet.

2. Verfahren zur Herstellung eines Musters gemäß Anspruch 1, wobei die Polymerisationsstartstelle (Y) eine Bindung ausgewählt aus C-C, C-N, C-O, C-Cl, N-O und S-N einschließt.

3. Verfahren zur Herstellung eines Musters gemäß Anspruch 1, welches weiterhin zur Bildung eines leitfähigen Musters den Schritt des Haftens eines leitfähigen Materials an dem Pfropfpolymer umfasst.

4. Verfahren zur Herstellung eines Musters gemäß Anspruch 3, wobei die Polymerisationsstartstelle eine Bindung ausgewählt aus C-C, C-N, C-O, C-Cl, N-O und S-N einschließt.

5. Verfahren zur Herstellung eines Musters gemäß Anspruch 1, welches weiterhin den Schritt des Haftens eines Metallions oder eines Metallsalzes an dem Pfropfpolymer; und,
zur Bildung eines leitfähigen Musters, Abscheiden des Metalls durch Reduzieren des Metallions oder des Metallions in dem Metallsalz umfasst.

6. Verfahren zur Herstellung eines Musters gemäß Anspruch 5, wobei die Polymerisationsstartstelle eine Bindung ausgewählt aus C-C, C-N, C-O, C-Cl, N-O und S-N einschließt.

7. Verfahren zur Herstellung eines Musters gemäß Anspruch 1, welches weiterhin den Schritt des Haftens eines stromlosen Plattierkatalysators oder eines Vorläufers davon an den Pfropfpolymer; und,
zur Bildung eines leitfähigen Musters, Herstellen einer musterförmigen dünnen Metallschicht durch stromloses Plattieren umfasst.

8. Verfahren zur Herstellung eines Musters gemäß Anspruch 7, wobei die Polymerisationsstartstelle eine Bindung ausgewählt aus C-C, C-N, C-O, C-Cl, N-O und S-N einschließt.

9. Verfahren zur Herstellung eines Musters gemäß Anspruch 7, welches im Anschluss an das stromlose Plattieren Galvanisieren umfasst.

10. Verfahren zur Herstellung eines Musters gemäß Anspruch 7, welches weiterhin den Schritt des Galvanisierens auf der dünnen Metallschicht umfasst.

## Revendications

1. Procédé de formation d'un motif consistant à :
lier un composé (Q-Y) ayant un site de liaison de substrat (Q) et un site d'initiation de photopolymérisation (Y), capable d'initier une polymérisation par voie radicalaire par photoclivage de celui-ci, à une surface d'un substrat ;
soumettre la surface à une exposition de motif pour rendre inactif le site d'initiation de photopolymérisation dans la région exposée ;
mettre en contact un composé insaturé polymérisable par voie radicalaire avec la surface ; et
soumettre la surface à une exposition à la lumière de toute la surface pour provoquer un clivage photochimique du site d'initiation de photopolymérisation (Y) restant dans la région qui n'était pas exposée dans l'exposition de motif,
dans lequel le clivage du site d'initiation de photopolymérisation (Y) initie une polymérisation par voie radicalaire pour former un polymère greffé.

2. Procédé de formation d'un motif selon la revendication 1, dans lequel le site d'initiation de polymérisation (Y) inclut une liaison sélectionnée parmi C-C, C-N, C-O, C-Cl, N-O et S-N.

3. Procédé de formation d'un motif selon la revendication 1, comprenant en outre l'étape consistant à faire adhérer un matériau conducteur au polymère greffé pour former un motif conducteur.

4. Procédé de formation d'un motif selon la revendication 3, dans lequel le site d'initiation de polymérisation inclut une liaison sélectionnée parmi C-C, C-N, C-O, C-Cl, N-O et S-N.

5. Procédé de formation d'un motif selon la revendication 1, comprenant en outre l'étape consistant à faire adhérer un ion métallique ou un sel métallique au polymère greffé ; et
le dépôt du métal par réduction de l'ion métallique ou de l'ion métallique dans le sel métallique pour former un motif conducteur.

6. Procédé de formation d'un motif selon la revendication 5, dans lequel le site d'initiation de polymérisation inclut une liaison sélectionnée parmi C-C, C-N, C-O, C-Cl, N-O et S-N.

7. Procédé de formation d'un motif selon la revendication 1, comprenant en outre l'étape consistant à faire adhérer un catalyseur de revêtement autocatalytique ou un précurseur de celui-ci au polymère greffé ; et
la formation d'un film métallique mince à motifs par revêtement autocatalytique pour former un motif conducteur.

8. Procédé de formation d'un motif selon la revendication 7, dans lequel le site d'initiation de polymérisation inclut une liaison sélectionnée parmi C-C, C-N, C-O, C-Cl, N-O et S-N.

9. Procédé de formation d'un motif selon la revendication 7, comprenant en outre la réalisation d'une galvanoplastie après le revêtement autocatalytique.

10. Procédé de formation d'un motif selon la revendication 7, comprenant en outre l'étape consistant à réaliser une galvanoplastie sur le film métallique mince.
